# EUROPÄISCHE PATENTANMELDUNG

(11) **EP 4 803 942 A1**
(43) Veröffentlichungstag der Anmeldung: **09.09.2026**
(21) Anmeldenummer: 26155111.3
(22) Anmeldetag: 29.01.2026
(51) Int. Cl.: G02B 6/28, G02B 6/42, G02B 26/08

(54) **EINKOPPLUNGSVORRICHTUNG ZUM EINKOPPELN WENIGSTENS EINES LASERSTRAHLS IN WENIGSTENS EIN FASER-ARRAY**

(30) Priorität: 04.03.2025 DE 102025108144
(71) Anmelder: FIBERBRIDGE PHOTONICS GMBH, 30419 Hannover (DE)
(72) Erfinder: Theeg, Thomas, 30926 Seelze (DE); Gersema, Philipp, 30419 Hannover (DE); Binhammer, Thomas, 30926 Seelze (DE)
(74) Vertreter: Holz, Christian

(57) **Zusammenfassung**

Die vorliegende Erfindung betrifft eine Einkopplungsvorrichtung (1) zum Einkoppeln wenigstens eines Laserstrahls (A) in wenigstens ein Faser-Array (11) mit wenigstens einem ersten Ablenkelement (13a) oder wenigstens einem ersten Strahlteiler (14a), welches/welcher ausgebildet und angeordnet ist, den Laserstrahl (A) aufzunehmen und mehrfach abzulenken oder zu teilen, wenigstens einem Fokussierelement (12), welches ausgebildet und angeordnet ist, die abgelenkten oder geteilten Laserstrahlen (A) aufzunehmen und zu fokussieren, und wenigstens dem Faser-Array (11), welches eine Mehrzahl von wenigstens eindimensional, vorzugsweise zweidimensional, zueinander angeordneten Faserelementen (11a) aufweist.

## Beschreibung

Die vorliegende Erfindung betrifft eine Einkopplungsvorrichtung zum Einkoppeln wenigstens eines Laserstrahls in wenigstens ein Faser-Array.

Auf vielen verschiedenen technischen Gebieten werden heutzutage Glasfasern verwendet. Zu den technischen und insbesondere hochtechnischen Anwendungen gehört die Verwendung von Glasfasern zur Lichtübertragung. So werden Glasfasern zur Datenübertragung mittels Licht verwendet; in diesem Fall können die Glasfasern auch als Lichtwellenleiter bzw. als passive Glasfasern bezeichnet werden. Auch werden Glasfasern in der Medizin zum Beispiel zur Beleuchtung sowie zur Erzeugung von Abbildungen zum Beispiel in Mikroskopen, in Inspektionskameras sowie in Endoskopen verwendet. Ferner werden Glasfasern bei Sensoren eingesetzt, welche dann als faseroptische Sensoren bezeichnet werden können.

Ein weiteres Anwendungsgebiet für Glasfasern stellt die Lasertechnik dar. Hier kann die Laserstrahlung als Signallichtstrahlung mittels einer passiven Glasfaser von einer Laserstrahlungsquelle als Signallichtquelle bzw. als Signallichtstrahlungsquelle zu einer Bearbeitungsstelle geleitet werden, um dort zum Beispiel in der Materialbearbeitung oder in der Medizin zum Beispiel ein Schneiden oder ein Schweißen durchzuführen. Auch kann der Laserstrahl als Laserstrahlung auf diese Art und Weise zum Beispiel in der Messtechnik, in der Mikroskopie oder in der Spektroskopie zum Beispiel einer Probe zugeführt werden. Der Einsatz von passiven Glasfasern zur Leitung eines Laserstrahls kann zum Beispiel bei Anwendungen im Maschinenbau, in der Telekommunikation, in der Medizintechnik sowie in der Sensortechnik erfolgen.

Glasfasern weisen üblicherweise einen Faserkern (Englisch: fiber core) auf, welcher aus reinem Glas wie zum Beispiel aus reinem Quarzglas besteht und im Fall von passiven Glasfasern häufig mit Germanium dotiert ist; bei aktiven Glasfasern werden üblicherweise Neodym, Ytterbium, Erbium, Thulium und Holmium als Dotierungselemente verwendet. In bestimmten Fällen kann auch der Fasermantel dotiert sein; dies gilt für passive und für aktive Glasfasern. In Abhängigkeit von der Größe und der numerischen Apertur des Faserkerns kann man zwischen Single-Mode und Multi-Mode Glasfasern unterscheiden. Außerdem kann der Faserkern noch polarisationserhaltende Eigenschaften für das Licht aufweisen und daher als polarisationserhaltende Glasfasern (PM) bezeichnet werden. Ferner kann es sich um photonische Kristallglasfasern sowie um Hollow-Core-Glasfasern handeln. Auch wenn sich das Haupanwendungsgebiet auf Glasfasern bezieht, können Polymerfasern oder Fasern aus anderen Materialien, zum Beispiel sogenannte Soft-Glass-Fibers für den mittleren IR Bereich, ebenfalls für derartige Anwendungen eingesetzt werden.

Der Faserkern wird üblicherweise radial von außen von wenigstens einem Fasermantel (Englisch: fiber cladding) umgeben, welcher üblicherweise in der Umfangsrichtung geschlossen ist und somit den Faserkern vollständig umgibt, von den beiden offenen Enden der Glasfaser abgesehen. Auch der Fasermantel besteht üblicherweise aus Quarzglas.

Üblicherweise werden sowohl passive Glasfasern als auch aktive Glasfasern von einer Faserbeschichtung (Englisch: fiber coating) aus zum Beispiel Polymer vergleichbar dem Fasermantel umgeben, welche dann der Glasfaser zugerechnet werden kann. Die Faserbeschichtung kann dem mechanischen Schutz des gläsernen Inneren der Glasfaser dienen sowie deren optische Eigenschaften beeinflussen. Üblicherweise dient bei Glasfasern, in denen das Licht ausschließlich im Faserkern geführt wird (Englisch: Single-Clad Glasfasern), die Faserbeschichtung primär dem mechanischen Schutz. Glasfasern, die Licht im Faserkern und im Fasermantel führen (Englisch: Double-Clad Glasfasern), sind üblicherweise mit einer Faserbeschichtung zur Erfüllung von mechanischen sowie von optischen Eigenschaften ausgeführt.

Zwei in der Praxis häufig vorkommende Querschnittsformen für den Fasermantel sind zylindrisch und oktogonal. Die oktogonale Form für den Fasermantel wird insbesondere bei aktiven Glasfasern eingesetzt.

Derartige Glasfasern können in großen Längen hergestellt werden und sind üblicherweise als Rollenwaren erhältlich. Der Durchmesser des Fasermantels variiert üblicherweise zwischen ca. 80 µm und ca. 1 mm. Besonders bei den größeren Faserdurchmessern wird in der Praxis häufig schon von Faserstäben gesprochen (Englisch: rod-type fiber).

Die Zuführung von Signallicht bzw. von Signallichtstrahlung kann somit über eine Glasfaser erfolgen, welche daher als Strahlführungsvorrichtung bezeichnet und als Kabel bzw. als Strahlzuführungskabel realisiert werden kann. Strahlzuführungskabel zur Führung der Signallichtstrahlung vom Lasersystem zur Anwendung bzw. zum Ort der Anwendung werden heute standardmäßig mit genau einer Glasfaser pro Strahlzuführungskabel realisiert.

Wie bereits erwähnt, bietet die Glasfaser den großen Vorteil, dass das Licht der Signallichtstrahlung über große Strecken in der Glasfaser flexibel z.B. an einem Roboterarm und sicher zum Anwendungsort geführt werden kann. Die einzelne Glasfaser emittiert am Anwendungsort typischerweise aus der einzelnen Glasfaser einen runden Laserstrahl aus einer Single-Mode oder Multi-Mode-Glasfaser.

Der Trend am Markt zeigt jedoch, dass man für viele Anwendungen wie z.B. für das Schweißen, für die additive Fertigung und für Oberflächenbearbeitungen sowie für die Reinigung von Materialien einen modifizierten Laserstrahl, d.h. mit speziellen Strahlprofil, der z.B. nicht perfekt rund ist, einsetzen möchte. Hieraus können für die jeweilige Applikation erhebliche Vorteile entstehen und somit bessere oder neue technische Lösungsansätze realisiert oder geringere Stückkosten erzielt werden.

Hierfür gibt es bereits verschiedene Strahlformungsansätze, den einzelnen runden Laserstrahl aus dem Strahlzuführungskabel für die Applikation entsprechend zu modifizieren bzw. zu formen. Dies führt für einige Applikationen zu großen Vorteilen.

Aus technologischen Gründen können jedoch bisher viele interessante bzw. notwendige Laserstrahlkonfigurationen nicht erreicht werden. Außerdem stößt der Leistungstransport über eine einzelne Glasfaser aus physikalischen und technischen Gründen an seine Grenzen. Weiterhin ist es für viele Anwendungen wünschenswert, die verfügbare optische Leistung für die entsprechende Applikation am Anwendungsort zu erhöhen, um z.B. besser Schweißen zu können oder additive Fertigungsprozesse schneller umzusetzen (z.B. Selective Laser Melting).

In jedem Fall ist es für viele Anwendungen nützlich oder erforderlich, die Signallichtstrahlung über eine gewissen Strecke bzw. Entfernung, insbesondere vom Ort der Erzeugung bzw. Verstärkung der Signallichtstrahlung, zu führen, zu leiten bzw. zu übertragen, um die Signallichtstrahlung dort zu nutzen bzw. zu verstärken oder zu verändern. Das Spektrum der Signallichtstrahlung kann eine Breite von wenigen kHz bis hin zu mehreren hundert THz aufweisen.

Die DE 10 2023 133 492.1 (unveröffentlicht) beschreibt eine Strahlführungsvorrichtung zur Führung von Signallichtstrahlung mit wenigstens einem Fasereintrittselement, welches ausgebildet ist, die Signallichtstrahlung aufzunehmen, mit wenigstens einem Faseraustrittselement, welches ausgebildet ist, die Signallichtstrahlung abzugeben, und mit einer Mehrzahl von Faserelementen, welche mit ihrem einen Ende mit dem Fasereintrittselement und mit dem gegenüberliegenden Ende mit dem Faseraustrittselement feststehend verbunden und ausgebildet sind, die Signallichtstrahlung vom Fasereintrittselement zum Faseraustrittselement zu führen.

Auf diese Art und Weise können mehrere Faserelemente sowohl an ihren Eingangsseiten mittels des gemeinsamen Fasereintrittselements als auch an ihren Ausgangsseiten mittels des gemeinsamen Faseraustrittselements jeweils feststehend miteinander verbunden werden, um einzelne Signallichtstrahlungen, Laserstrahlungen bzw. Laserstrahlen parallel zueinander zu führen. Hierdurch kann eine Strahlführungsvorrichtung geschaffen werden, um mehrere Signallichtstrahlungen durch die Faserelemente hindurch parallel zueinander vom Fasereintrittselement zum Faseraustrittselement zu führen, so dass die Signallichtstrahlungen auf der Seite des Fasereintrittselements erzeugt und bzw. oder verstärkt und auf der Seite des Faseraustrittselements gemeinsam zur Anwendung gebracht bzw. genutzt werden können.

Die Aufnahme der Signallichtstrahlung, Laserstrahlungen bzw. der Laserstrahlen mittels des Fasereintrittselements kann über eine Freistrahlkopplung in die Faserelemente oder über eine stoffschlüssige Verbindung (z.B. Faserspleißverbindung) mit den Faserelementen realisiert werden. Es kann auch eine Einkopplung der Signallichtstrahlung bzw. der Signallichtstrahlungen mittels einer Strahlführungs- und -umlenkeinheit in die Faserelemente am Fasereintrittselement hinein erfolgen. Hierzu kann ein Galvoscanner, ein akusto-optischen Deflektor, auch akustooptischer Modulator genannt, oder ein anderes Strahlablenksystem genutzt werden.

Eine Aufgabe der vorliegenden Erfindung ist es, die Möglichkeiten der Einkopplung von Laserstrahlen in eine Mehrzahl von Faserelementen zu verbessern und bzw. oder zu erweitern. Das Einkoppeln soll insbesondere für Laserstrahlen mit vergleichsweise hohen Leistungen wie insbesondere von mehr als 100 W erfolgen können. Zusätzlich oder alternativ soll das Einkoppeln in die Faserelemente gleichzeitig oder nacheinander erfolgen können. Dies soll insbesondere für einen Laserstrahl einer Laserquelle oder für mehrere Laserstrahlen mehrerer Laserquellen erfolgen können. Dies soll insbesondere möglichst flexibel umsetzbar und bzw. oder nutzbar erfolgen können. In jedem Fall soll dies insbesondere für Laserstrahlen für industrielle Anwendungen in der Bearbeitung von Werkstücken wie beispielsweise Laserschweißen erfolgen können. Zumindest soll eine Alternative zu den bekannten Möglichkeiten geschaffen werden.

Die Aufgabe wird erfindungsgemäß durch eine Einkopplungsvorrichtung mit den Merkmalen des Patentanspruchs 1 gelöst. Vorteilhafte Weiterbildungen sind in den Unteransprüchen beschrieben.

Somit betrifft die vorliegende Erfindung eine Einkopplungsvorrichtung zum Einkoppeln wenigstens eines Laserstrahls in wenigstens ein Faser-Array mit wenigstens einem ersten Ablenkelement oder wenigstens einem ersten Strahlteiler, welches bzw. welcher ausgebildet und angeordnet ist, den Laserstrahl aufzunehmen und mehrfach abzulenken oder zu teilen, mit wenigstens einem Fokussierelement, welches ausgebildet und angeordnet ist, die abgelenkten oder geteilten Laserstrahlen aufzunehmen und zu fokussieren, und mit wenigstens dem Faser-Array, welches eine Mehrzahl von wenigstens eindimensional, vorzugsweise zweidimensional, zueinander angeordneten Faserelementen aufweist.

Der Laserstrahl kann sich aus kontinuierlicher oder gepulster Strahlung zusammensetzen mit einer beliebigen optischen Zentralwellenlänge. Der Laserstrahl kann auch als Laserstrahlung bezeichnet werden.

Unter einem Ablenkelement wird jegliche Möglichkeit verstanden, einen eingehenden einzelnen Laserstrahl auf der einen Seite aufzunehmen und mittels des Ablenkelements auf der anderen, vorzugsweise gegenüberliegenden, Seite wieder mit möglichst unveränderter optischen Leistung abzugeben, jedoch als wenigstens zwei Laserstrahlen. Die ausgehenden Laserstrahlen können in wenigstens zwei unterschiedliche Richtungen oder in zwei gleiche Richtungen, d.h. parallel zueinander, verlaufen. Diese beiden Richtungen können durch eine Steuerung einstellbar bzw. beeinflussbar sein. Dies kann insbesondere mittels eines nicht-mechanischen Ablenkelements erfolgen. Dies kann vorzugsweise mittels eines akusto-optischen Modulators (AOM) umgesetzt werden, welcher den eingehenden Laserstrahl vollständig in alternative Richtungen ablenken kann.

Somit können wenigstens zwei ausgehende Laserstahlen erzeugt werden, welche jeweils die optische Leistung des eingehenden Laserstrahls zumindest im Wesentlichen besitzen und in unterschiedliche Richtungen abgegeben bzw. ausgesendet werden, so dass die beiden ausgehenden Laserstrahlen als mehrere Laserstrahlen bezeichnet werden können, welche zeitlich versetzt bzw. alternativ zueinander existieren können. Insbesondere kann seitens des Ablenkelements zwischen diesen beiden ausgehenden bzw. resultierenden Laserstrahlen hin und her geschaltet werden.

In jedem Fall kann auf diese Art und Weise erfindungsgemäß ein einzelner Laserstahl vom ersten Ablenkelement aufgenommen und alternativ in wenigstens zwei Richtungen als alternative Laserstrahlen zum Fokussierelement hin weitergeleitet werden, so dass die beiden ausgehenden Laserstrahlen dort jeweils fokussiert und dann, d.h. in fokussierter Form, in jeweils ein Faserelement des Faser-Arrays eingekoppelt werden können. Dort können die beiden Laserstrahlen verlaufen bzw. geführt werden und am Ende des Faser-Arrays eine Anwendung erreichen können, auf welche die beiden Laserstrahlen nacheinander bzw. alternativ zueinander wirken können.

Alternativ kann ein derartiges Ablenkelement auch wie ein Strahlteiler wirken, welcher nachfolgend näher beschrieben werden wird, und den eingehenden Laserstrahl in wenigstens zwei zeitgleich existierende ausgehende Laserstrahlen aufteilen. Dies kann als zeitlich statisch bezeichnet werden, wohingegen die Erzeugung zeitlich versetzter Laserstrahlen als zeitlich dynamisch bezeichnet werden kann.

Unter einem Strahlteiler wird dabei jegliche Möglichkeit verstanden, einen eingehenden einzelnen Laserstrahl auf der einen Seite aufzunehmen und mittels des Strahlteilers in wenigstens zwei ausgehende Laserstrahlen aufzuteilen, welche gleichzeitig in jeweils einer Richtung, vorzugsweise parallel zueinander, aus dem Strahlteiler wieder austreten. In diesem Fall teilt sich somit die optische Leistung des eingehenden Laserstrahls auf die beiden austretenden bzw. ausgehenden Laserstrahlen auf, so dass die Summe der optischen Leistungen der beiden ausgehenden Laserstrahlen zumindest im Wesentlichen der optischen Leistung des eingehenden Laserstrahls entspricht. Dies kann vorzugsweise mittels ein diffraktives optisches Element (DOE), mittels eines Gitters, mittels eines LCD-Displays oder mittels eines zeitlich statischen akusto-optischen Modulators (AOM), welcher gleichzeitig wenigstens zwei austretende Laserstrahlen erzeugen kann, umgesetzt werden.

In jedem Fall kann auf diese Art und Weise erfindungsgemäß alternativ ein einzelner Laserstrahl vom ersten Strahlteiler aufgenommen und gleichzeitig in wenigstens zwei Richtungen als gleichzeitige Laserstrahlen zum Fokussierelement hin weitergeleitet werden, so dass die beiden ausgehenden Laserstrahlen dort jeweils fokussiert und dann, d.h. in fokussierter Form, in jeweils ein Faserelement des Faser-Arrays eingekoppelt werden können. Dort können die beiden Laserstrahlen weitergeleitet bzw. geführt werden und am Ende des Faser-Arrays eine Anwendung erreichen, auf welche die beiden Laserstrahlen gleichzeitig bzw. gemeinsam wirken können.

Die Faserelemente bzw. die Lichtleitfasern des Faser-Arrays können dabei, zumindest dort, wo das Eintreten bzw. das Einkoppeln der Laserstrahlen erfolgen kann, eindimensional oder zweidimensional zueinander angeordnet sein, was den Gestaltungsspielraum der Anordnung der Faserelemente, zumindest am Ort des Eintretens bzw. des Einkoppelns, und damit auch den Gestaltungsspielraum der Anordnung der übrigen Elemente der erfindungsgemäßen Einkopplungsvorrichtung, erhöhen kann. Die eindimensionale Anordnung der Faserelemente kann auch als linienförmig bzw. als geradlinig bezeichnet werden. Alternativ kann eine zweidimensionale Anordnung von Faserelementen mehrere Faserelemente aufweisen, welche in zwei Raumrichtungen nebeneinander angeordnet sein können, wie beispielsweise ein zweidimensionale Matrix, oder auch eine Anordnung von Faserelementen, welche hintereinander angeordnet sind, jedoch in einer zweidimensionalen Geometrie wie beispielsweise einem Bogen, einem Kreis, einem Oval, einem Rechteck oder Viereck, ein Hexagon oder dergleichen.

In jedem Fall können die Faserelemente im Verlauf des Faser-Arrays gleichbleibend weitergeführt werden oder die Anordnung der Faserelemente kann sich abschnittsweise oder vollständig über die Länge des Faser-Arrays verändern. Insbesondere kann die Anordnung der Faserelemente des Faser-Arrays am Ort des Austritts der Laserstrahlung gleich oder anders als beim Eintreten sein, was ebenfalls den Gestaltungsspielraum, insbesondere zur Nutzung der austretenden Laserstrahlung, erhöhen kann.

Dem Faser-Array entsprechend kann das erste Ablenkelement bzw. der erste Strahlteiler ausgebildet sein, um eine eindimensionale oder zweidimensionale Anordnung von austretenden Laserstrahlungen erzeugen, welche jeweils durch das Fokussierelement hindurch in die entsprechenden Faserelemente des Faser-Arrays eingekoppelt werden können.

In jedem Fall kann als Fokussierelement jegliche Art von Optik verwendet werden, welche eine optische Fokussierung von wenigstens zwei Laserstrahlen zum Faser-Array hin bewirken kann. Hierzu kann ein einstückiges, d.h. integral ausgebildetes, Fokussierelement wie beispielsweise eine einzelne Linse verwendet werden. Es können ebenso mehrere einzelne Elemente verwendet werden, welche jeweils einen Laserstrahl fokussieren und somit gemeinsam funktionell zusammenwirken, um gemeinsam als Fokussierelement bezeichnet zu werden.

In jedem Fall können zwischen dem ersten Ablenkelement bzw. dem ersten Strahlteiler, dem Fokussierelement und dem Faser-Array bzw. dessen Eintrittsseite noch weitere optische Elemente entlang der Ausbreitungsrichtung der Laserstrahlen angeordnet werden, wie nachfolgend noch näher beschrieben werden wird.

In jedem Fall kann das erste Ablenkelement mehr als zwei zeitlich versetzt oder zeitgleich austretende Laserstrahlen erzeugen. Ebenso kann der Strahlteiler mehr als zwei zeitgleich austretende Laserstrahlen erzeugen. Dies kann den Gestaltungsspielraum der erfindungsgemäßen Einkopplungsvorrichtung weiter erhöhen.

Insbesondere können die Eigenschaften des ersten Ablenkelements und bzw. oder des ersten Strahlteilers in wenigstens zwei Schritten bzw. in wenigstens zwei Ebenen, funktionell bzw. räumlich entlang der Ausbreitungsrichtung der Laserstrahlen hintereinander angeordnet, miteinander kombiniert werden, um den Gestaltungsspielraum der erfindungsgemäßen Einkopplungsvorrichtung weiter zu erhöhen. Dabei können ausschließlich Ablenkelemente oder Strahlteiler in beiden bzw. in allen Ebenen verwendet werden. Alternativ können auch Ablenkelemente und Strahlteiler in beiden bzw. in allen Ebenen miteinander kombiniert werden. Bevorzugte Kombinationsmöglichkeiten werden nachfolgend näher beschrieben werden. Dies kann auch für mehr als zwei Ebenen hintereinander erfolgen. Dabei können stets gleiche oder unterschiedliche Ablenkelemente und bzw. oder Strahlteiler verwendet bzw. miteinander kombiniert werden.

Das Ablenkelement oder der Strahlteiler kann die Teilstrahlen in jeweils unterschiedliche und nicht parallel verlaufende Richtungen emittieren, wie bereits zuvor erwähnt. Für die Einkopplung und für die Anordnung der Faserelemente kann diese Richtung jeweils für jeden Teilstrahl ausgeglichen oder berücksichtigt werden. Vorzugsweise kann die Einkopplungsanordnung daher ein winkelkorrigierendes Element aufweisen, welches die einzelnen Teilstrahlen parallel ausrichten kann. Diese kann, wie nachfolgend noch näher erläutert werden wird, durch eine passende Geometrie. durch einen Abstand des Fokussierelements oder durch eine Anordnung von Keilen oder eine Freiform-Optik erfolgen.

Die Strahlparameter des Laserstrahls können vorzugsweise in der Einkopplungsvorrichtung derart gestaltet werden, dass die Strahlradien an den Ablenk- oder Strahlteilungselementen groß genug sind, um thermische Probleme und Zerstörung der Bauteile zu verhindern und gleichzeitig vor jedem Faserelement passend positioniert sind und einem der Faser entsprechend kleinen Strahlradius auftreffen, was eine effiziente und zerstörungsfreie Einkopplung ermöglichen kann.

Insbesondere kann die ein- oder mehrdimensionale Anordnung der Ein- und bzw. oder Austrittsfasern des Faser-Arrays von Bedeutung sein, wobei die Geometrie der Anordnung der Faserelemente auf Ein- und Austrittseite sich unterscheiden kann. Eine Mehrzahl an Faserelementen in einer festen geometrischen Anordnung, die entweder gleichzeitig, d.h. zeitlich statisch, oder zeitlich versetzt, d.h. zeitlich dynamisch, Laserstrahlung emittieren können, kann zahlreiche neue Technologien und bzw. oder Verfahren eröffnen. Dabei kann die Laserstrahlung aus den jeweiligen Kanälen sowohl kohärent oder inkohärent zueinander sein. In jedem Fall kann die Erzeugung von parallel verlaufenden Laserstrahlen zu einem gemeinsamen Anwendungsort hin als Multi-Beam bezeichnet werden.

In der Materialbearbeitung können Multi-Beam-Anordnungen eine Skalierung der Laserleistung oder eine Parallelisierung der Bearbeitungsprozesse und dadurch höhere Geschwindigkeit und Produktivität ermöglichen. Gezielte Mustererzeugung oder Strahlformung kann neue Prozesstechniken z.B. in der Oberflächen-Strukturierung ermöglichen. Die kohärente oder inkohärente Überlagerung mehrerer Hochleistungslaser mittels eines derartigen Faser-Arrays kann eine Skalierung der Laserleistung in den Bereich oberhalb 10 kW ermöglichen. Dies kann die Grundlage für viele Anwendungen in der Verteidigungs- oder Raumfahrt-Industrie wie z.B. in der Satellitenkommunikation darstellen. Schnell schaltbare oder dynamisch modifizierbare Laserstrahlen aus Faser-Arrays können zudem Anwendung im Bereich Quanten-Computing oder in der Kommunikation finden. Dabei kann technologisch bereits eine Zahl von mehr als hundert Kanälen in derartigen Faser-Arrays hochpräzise angeordnet werden. Dies verdeutlicht die Notwendigkeit neuer technologischer Ansätze zur zeitlich dynamischen oder zeitlich statischen Einkopplung einer oder mehrerer Laserquellen in eine Vielzahl von Glasfasern, insbesondere die Einkopplung in Single-Mode oder LMA-Fasern.

Während Technologien zur Strahlablenkung und Stahlaufteilung an sich weitgehend als Stand der Technik bekannt sind, ist die Kombination von Strahlablenkung oder von Stahlaufteilung und Einkopplung des in einzelne Laserstrahlen aufgeteilten Laserstrahls in ein Faser-Array bislang nicht bekannt. Die Kombination aus Strahlaufteilung, ob durch gleichzeitige Aufteilung oder durch zeitlich versetzte Ablenkung, eines eingehenden Laserstrahls in mehrere Kanäle bzw. in einzelne Laserstrahlen und deren Einkopplung in ein gemeinsames Faser-Array z.B. in Form einer Glasfaser, insbesondere eine Single-Mode oder Large-Mode-Area-(LMA-)Glasfaser, kann es ermöglichen, die entsprechenden Strahldurchmesser und Winkel für das jeweilige Ablenkelement bzw. für den jeweiligen Strahlteiler und eine effiziente sowie schädigungsfreie Einkopplung in jedes einzelne Faserelement des Faser-Arrays zu gewährleisten, was in dieser Form über den Stand der Technik hinausgeht. Insbesondere für den Hochleistungslaserbereich mit mehr als 100 W Leistung können auf diese Art und Weise Zerstörschwellen, thermische Effekte und Streustrahlung beachtet werden. Erfindungsgemäß können für das Ablenkelement oder für den Strahlteiler große Strahlradien für hohe Effizienz und Minimierung thermischer Effekte ermöglicht werden sowie die Aufteilung oder Ablenkung mit sehr geringem Winkel erfolgen, insbesondere mit wenigen mrad im Fall eines akusto-optischen Modulators (AOM) oder diffraktiven optischen Elements (DOE).

Um dabei eine vollständige Trennung der einzelnen Moden der durch Ablenkung oder Strahlteilung erzeugten einzelnen Laserstrahlen als Unterstrahlen zu erreichen, können lange Wegstreckenerforderlich werden, die in der Praxis aber oft mangels Kompaktheit und geringer Stabilität nachteilig sein können. Daher kann eine einfache Skalierung der Abstände vorteilhaft sein, wie nachfolgend noch näher beschrieben werden wird. Die Winkeldivergenz der Teilstrahlen kann ausgeglichen werden und eine Fokussierung jedes Einzelstrahls an die passende Position der jeweiligen Glasfaser des Faser-Arrays in der Form erfolgen, dass ein optimale Einkoppeleffizienz erreicht werden kann. Nicht eingekoppeltes Licht, sei es zwischen den Faserelementen oder in einer Cladding Mode geführtes Licht, kann vorzugsweise kontrolliert und entfernt werden, da es insbesondere im hohen Leistungsbereich zu unerwünschten thermischen Effekten oder Zerstörung führen kann.

Gemäß einem Aspekt der Erfindung weist die Einkopplungsvorrichtung wenigstens das erste Ablenkelement auf, welches ausgebildet und angeordnet ist, den Laserstrahl aufzunehmen und mehrfach abzulenken, und ferner wenigstens einen ersten Strahlteiler, welcher ausgebildet und angeordnet ist, einen der abgelenkten Laserstrahlen aufzunehmen und zum Fokussierelement zu teilen.

Dies kann eine konkrete Möglichkeit darstellen, den eingehenden Laserstrahl zwei Mal hintereinander abzulenken und bzw. oder zu teilen, wie zuvor bereits beschrieben. In diesem Fall können die Eigenschaften eines Ablenkelements in der ersten Ebene und eines Strahlteilers in der zweiten Ebene, d.h. in dieser Reihenfolge, miteinander kombiniert werden. Dabei können sowohl das Ablenkelement als auch der Strahlteiler eindimensional oder zweidimensional ablenkend bzw. strahlteilend ausgebildet sein. Insbesondere können sowohl das Ablenkelement als auch der Strahlteiler eindimensional ablenkend bzw. strahlteilend ausgebildet und zueinander angeordnet sein, um eine zweidimensionale Anordnung von Laserstrahlen zu erzeugen und durch das Fokussierelement hindurch in die entsprechenden Faserelemente des Faser-Arrays einzukoppeln.

Gemäß einem weiteren Aspekt der Erfindung weist die Einkopplungsvorrichtung ferner wenigstens zwei erste Strahlteiler auf, welche ausgebildet und angeordnet sind, jeweils einen der abgelenkten Laserstrahlen aufzunehmen und zum Fokussierelement zu teilen.

Dies kann eine alternative konkrete Möglichkeit darstellen, den eingehenden Laserstrahl zwei Mal hintereinander abzulenken und bzw. oder zu teilen, wie zuvor bereits beschrieben. In diesem Fall können die Eigenschaften eines Ablenkelements in der ersten Ebene und mehrerer parallel angeordneter bzw. wirkender Strahlteiler in der zweiten Ebene, d.h. in dieser Reihenfolge, miteinander kombiniert werden, wie zuvor bereits beschrieben, nun jedoch mittels mehrerer Strahlteiler. Vorzugsweise können dabei ausschließlich Strahlteiler in der zweiten Ebene verwendet werden, um die Eigenschaften von Strahlteilern einheitlich pro Ebene zu nutzen.

Gemäß einem weiteren Aspekt der Erfindung weist die Einkopplungsvorrichtung ferner wenigstens ein zweites Ablenkelement auf, welches ausgebildet und angeordnet ist, den anderen der abgelenkten Laserstrahlen aufzunehmen und zum Fokussierelement mehrfach abzulenken.

Dies kann eine alternative konkrete Möglichkeit darstellen, den eingehenden Laserstrahl zwei Mal hintereinander abzulenken und bzw. oder zu teilen, wie zuvor bereits beschrieben. In diesem Fall können die Eigenschaften eines Ablenkelements in der ersten Ebene sowie funktionell parallel zueinander wenigstens eines ersten Strahlteilers und wenigstens eines zweiten Ablenkelements in der zweiten Ebene, d.h. in dieser Reihenfolge, miteinander kombiniert werden, wie zuvor bereits beschrieben. Entsprechend können die Eigenschaften von Strahlteilern und Ablenkelementen in der zweiten Ebene miteinander kombiniert werden.

Gemäß einem weiteren Aspekt der Erfindung weist die Einkopplungsvorrichtung wenigstens den ersten Strahlteiler auf, welcher ausgebildet und angeordnet ist, den Laserstrahl aufzunehmen und zu teilen, und ferner wenigstens ein erstes Ablenkelement, welcher ausgebildet und angeordnet ist, einen der geteilten Laserstrahlen aufzunehmen und zum Fokussierelement mehrfach abzulenken.

Dies kann eine alternative konkrete Möglichkeit darstellen, den eingehenden Laserstrahl zwei Mal hintereinander abzulenken und bzw. oder zu teilen, wie zuvor bereits beschrieben. In diesem Fall erfolgt zunächst eine Strahlteilung mittels des ersten Strahlteilers in der ersten Ebene und anschließend eine Ablenkung eines der Laserstrahlen mittels des ersten Ablenkelements in der zweiten Ebene. Dies kann die Gestaltungsmöglichkeiten erhöhen.

Gemäß einem weiteren Aspekt der Erfindung weist die Einkopplungsvorrichtung ferner wenigstens zwei erste Ablenkelemente auf, welche ausgebildet und angeordnet sind, jeweils einen der geteilten Laserstrahlen aufzunehmen und zum Fokussierelement mehrfach abzulenken.

Dies kann eine alternative konkrete Möglichkeit darstellen, den eingehenden Laserstrahl zwei Mal hintereinander abzulenken und bzw. oder zu teilen, wie zuvor bereits beschrieben. In diesem Fall werden wenigstens zwei Laserstrahlen in der zweiten Ebenen parallel bzw. gleichzeitig erneut abgelenkt, was jeweils durch ein erstes Ablenkelement erfolgt. Vorzugsweise werden ausschließlich erste Ablenkelemente in der zweiten Ebene verwendet, um die Eigenschaften von Ablenkelementen einheitlich pro Ebene zu nutzen. Dies kann die Gestaltungsmöglichkeiten erhöhen.

Gemäß einem weiteren Aspekt der Erfindung weist die Einkopplungsvorrichtung ferner wenigstens einen zweiten Strahlteiler auf, welcher ausgebildet und angeordnet ist, den anderen der geteilten Laserstrahlen aufzunehmen und zum Fokussierelement zu teilen.

Dies kann eine alternative konkrete Möglichkeit darstellen, den eingehenden Laserstrahl zwei Mal hintereinander abzulenken und bzw. oder zu teilen, wie zuvor bereits beschrieben. Auch in diesem Fall können die Eigenschaften von Strahlteilern und Ablenkelementen in zwei Ebenen hintereinander miteinander kombiniert werden.

Gemäß einem weiteren Aspekt der Erfindung weist die Einkopplungsvorrichtung das erste Ablenkelement auf, welches ausgebildet und angeordnet ist, den Laserstrahl aufzunehmen und mehrfach abzulenken, und ferner wenigstens zwei zweite Ablenkelemente, welche ausgebildet und angeordnet sind, jeweils den einen der abgelenkten Laserstrahlen vom ersten Ablenkelement aufzunehmen und zum Fokussierelement mehrfach abzulenken.

Dies kann eine alternative konkrete Möglichkeit darstellen, den eingehenden Laserstrahl zwei Mal hintereinander abzulenken, wie zuvor bereits beschrieben, wobei in diesem Fall vorzugsweise eine ausschließliche Verwendung von Ablenkelementen in beiden Ebenen erfolgen kann.

Gemäß einem weiteren Aspekt der Erfindung weist die Einkopplungsvorrichtung den ersten Strahlteiler auf, welcher ausgebildet und angeordnet ist, den Laserstrahl aufzunehmen und zu teilen, und ferner wenigstens zwei zweite Strahlteiler, welche ausgebildet und angeordnet sind, jeweils einen der geteilten Laserstrahlen vom ersten Strahlteiler aufzunehmen und zum Fokussierelement zu teilen.

Dies kann eine alternative konkrete Möglichkeit darstellen, den eingehenden Laserstrahl zwei Mal hintereinander zu teilen, wie zuvor bereits beschrieben, wobei in diesem Fall vorzugsweise eine ausschließliche Verwendung von Strahlteilern in beiden Ebenen erfolgen kann.

Gemäß einem weiteren Aspekt der Erfindung ist das erste Ablenkelement ein erster akustooptischer Modulator (AOM), vorzugsweise und ein zweites Ablenkelement ist ein zweiter akustooptischer Modulator.

Dies kann eine konkrete Möglichkeit der Umsetzung darstellen, um die entsprechenden Eigenschaften und Vorteile zu nutzen.

Gemäß einem weiteren Aspekt der Erfindung ist das erste Ablenkelement, vorzugsweise und ein zweites Ablenkelement, ausgebildet, den Laserstrahl eindimensional oder zweidimensional abzulenken.

Dies kann eine konkrete Möglichkeit der Umsetzung darstellen, wie zuvor bereits beschrieben.

Gemäß einem weiteren Aspekt der Erfindung ist der erste Strahlteiler ein erstes diffraktives optisches Element, vorzugweise und ein zweiter Strahlteiler ist ein zweites diffraktives optisches Element.

Dies kann eine konkrete Möglichkeit der Umsetzung darstellen, um die entsprechenden Eigenschaften und Vorteile zu nutzen.

Gemäß einem weiteren Aspekt der Erfindung ist der erste Strahlteiler, vorzugweise und ein zweiter Strahlteiler, ausgebildet, den Laserstrahl eindimensional oder zweidimensional zu teilen.

Dies kann eine konkrete Möglichkeit der Umsetzung darstellen, wie zuvor bereits beschrieben.

Gemäß einem weiteren Aspekt der Erfindung ist das Fokussierelement eine Linse, ein Mikro-Linsen-Array, ein Hohlspiegel, ein Paraboloid oder eine Freiformoptik.

Dies können verschiedene konkrete Möglichkeiten der Umsetzung darstellen, um die entsprechenden Eigenschaften und Vorteile zu nutzen.

Gemäß einem weiteren Aspekt der Erfindung ist das Fokussierelement im Abstand seiner Brennweite zum ersten Ablenkelement oder zum ersten Strahlteiler, vorzugsweise oder zu wenigstens einem zweiten Ablenkelement oder zu wenigstens einem zweiten Strahlteiler, angeordnet und das Faser-Array ist im Abstand der Brennweite des Fokussierelements zum Fokussierelement angeordnet.

Eine derartige optische Anordnung kann als 2f-Aufbau bezeichnet werden, welcher dafür sorgen kann, dass die Winkeldivergenz des ersten Ablenkelements, vorzugsweise als diffraktives Element, korrigiert werden kann und die einzelnen Strahl-Größen der Einzelstrahlen, d.h. der einzelnen Laserstrahlen, in der Fourier-Ebene fokussiert werden können, wo das Faser-Array angeordnet werden kann.

Gemäß einem weiteren Aspekt der Erfindung weist die Einkopplungsvorrichtung ferner wenigstens eine Vergrößerungsvorrichtung, vorzugsweise mit wenigstens einer Spiegelstrecke oder einer Abbildungsoptik, auf, welche ausgebildet und angeordnet ist, die abgelenkten oder geteilten Laserstrahlen vom ersten Ablenkelement oder vom ersten Strahlteiler, vorzugsweise oder von wenigstens einem zweiten Ablenkelement oder von wenigstens einem zweiten Strahlteiler, aufzunehmen und zum Fokussierelement zu führen und dabei in ihrem Abstand zueinander zu vergrößern.

Dies kann zu einer Abstandsvergrößerung der Laserstrahlen führen, die vorzugsweise eine vollständige räumliche Trennung der Einzelstrahlen oder eine größere Mode des Einzelstrahls ermöglicht, die vorteilhaft für die Einkopplung sein kann. Hierdurch kann auch der Abstand der Faserelemente des Faser-Arrays zueinander vergrößert werden, beispielsweise durch eine Beabstandung der Faserelemente zueinander und bzw. oder durch die Verwendung von Faserelementen mit entsprechend großem Querschnitt. Somit können die Laserstrahlen gegenüber einander aufgeweitet werden, d.h. in ihrem Abstand zueinander zumindest im Wesentlichen senkrecht zu ihrer Ausbreitungsrichtung vergrößert werden. Dies kann den Gestaltungsspielraum erhöhen. Dies kann mittels einer Spiegelstrecke oder einer Abbildungsoptik vergleichsweise einfach erfolgen.

Gemäß einem weiteren Aspekt der Erfindung weist die Einkopplungsvorrichtung ferner wenigstens eine Teleskopvorrichtung auf, welche ausgebildet und angeordnet ist, die abgelenkten oder geteilten Laserstrahlen vom ersten Ablenkelement oder vom ersten Strahlteiler, vorzugsweise oder von wenigstens einem zweiten Ablenkelement oder von wenigstens einem zweiten Strahlteiler, aufzunehmen und zum Fokussierelement zu führen und dabei ihre Winkelaufweitung zu vergrößern sowie die Strahlgröße zu verkleinern.

Die Verwendung einer Teleskopvorrichtung kann es ermöglichen, eine Vergrößerung der Winkelaufweitung bei gleichzeitiger Verkleinerung der Strahlgrößen zu erreichen, was die Gestaltungsmöglichkeiten weiter verbessern bzw. erweitern kann. Hierdurch kann zugunsten einer effizienten und kanal-getrennten Einkopplung in das Faser-Array vorzugsweise erreicht werden, dass die Einzelstrahlen am Ort des Faser-Arrays eine Modengröße aufweisen, welche zur Modenfeldgröße der Faser passt und den richtigen Abstand der Kanäle bzw. Laserstrahlen entsprechend dem Pitch der Fasern aufweist. Als Pitch kann dabei der Abstand der jeweiligen einzelnen Faserelemente innerhalb des Faser-Arrays bezeichnet werden. Da die benötigten Foki je nach Faser sehr klein sein können, beispielsweise ca. 3 µm bis ca. 10 µm Radius, kann ein Mikro-Linsen Array, welches direkt vor die Faserelementen platziert wird, vorteilhaft sein, um unmittelbar vor dem Eintritt der Laserstrahlen in die Faserelemente des Faser-Arrays eine zusätzliche Fokussierung zu erreichen. Um dieses nutzen zu können, können die Modengröße der Einzelstrahlen bzw. der Laserstrahlen kleiner als der Pitch sein und soweit aufgespalten, dass sich die Einzelstrahlen nicht überlappen. Dazu kann die Teleskopvorrichtung dienen und somit die mögliche Kanal-Zahl deutlich erhöhen.

Gemäß einem weiteren Aspekt der Erfindung weist die Einkopplungsvorrichtung ferner eine Mehrzahl von Mikro-Linsen auf, welche ausgebildet und angeordnet sind, jeweils genau einen abgelenkten oder geteilten Laserstrahl vom Fokussierelement aufzunehmen und jeweils zu genau einer der Faserelemente des Faser-Arrays zu führen und dabei weiter zu fokussieren.

Dies kann die Fokussierung der Laserstrahlen insbesondere bei kleinen Foki der Faserelemente des Faser-Arrays verbessern, wie zuvor bereits beschrieben.

Gemäß einem weiteren Aspekt der Erfindung ist das Fokussierelement in einem Abstand unterhalb seiner Brennweite zum ersten Ablenkelement oder zum ersten Strahlteiler, vorzugsweise oder zu einem zweiten Ablenkelement oder zu einem zweiten Strahlteiler, angeordnet, wobei die Einkopplungsvorrichtung ferner eine Mehrzahl von Mikro-Keilen aufweist, welche ausgebildet und angeordnet sind, jeweils genau einen abgelenkten oder geteilten Laserstrahl vom Fokussierelement aufzunehmen und jeweils zu genau einer der Faserelemente des Faser-Arrays zu führen.

Die zu erreichenden Strahlradien können in diesem Fall für Single-Mode-Fasern oder für LMA Fasern im Bereich 3 µm bis 15 µm liegen. Der auszufüllenden Raumbereich gegeben durch den Pitch-Abstand des Arrays und der Kanalzahl, kombiniert mit kleinen Aufspaltwinkeln der Ablenkelemente, kann in einer einfachen Anordnung langbrennweitige Fokussierelemente notwendig machen, die nicht geeignet sind, diese kleine Strahlradien an der Einkoppelstelle zu erreichen. Diese Verknüpfung von Geometrie und Fokusgröße kann erfindungsgemäß auf diese Art und Weise aufgehoben werden.

Die Mehrzahl von Mikro-Keilen können die Laserstrahlen parallelisieren, bevor die Laserstrahlen das Faser-Array bzw. dessen Faserelementen erreichen. Dabei kann das Fokussierelement so gewählt werden, dass der Strahldurchmesser der Einzelstrahlen bzw. der Laserstrahlen im Fokus zu dem jeweiligen Faserelement passt. An dem Fokussierelement können sich die Laserstrahlen überlappen, so dass die Laserstrahlen erst an der Position der Mikro-Keile getrennt werden können. Dieser Aufbau kann ein Mikro-Linsen-Array als Fokussierelement vermeiden.

Gemäß einem weiteren Aspekt der Erfindung ist das Fokussierelement ein Mikro-Linsen-Array, wobei die Mikro-Linsen des Mirko-Linsen-Arrays gemeinsam eine gekrümmte Oberfläche bilden, welche ausgebildet ist, die abgelenkten oder geteilten Laserstrahl jeweils von genau einer Mikro-Linsen des Mikro-Linsen-Arrays geradlinig aufzunehmen und geradlinig zum Fokussierelement zu führen.

Hierdurch kann ein vergleichsweise einfacher Aufbau realisiert werden, welcher jedoch eine sehr präzise Ausrichtung der Faserelemente des Faser-Arrays und der einzelnen Mikro-Linsen des Mikro-Linsen-Arrays erfordern kann. Dabei kann es notwendig sein, dass die Modendurchmesser der Einzelstrahlen kleiner als der Pitch der Kanäle sind.

Gemäß einem weiteren Aspekt der Erfindung ist das Fokussierelement ein Mikro-Linsen-Array, wobei die Einkopplungsvorrichtung ferner eine Mehrzahl von Mikro-Keilen aufweist, welche ausgebildet und angeordnet sind, jeweils genau einen abgelenkten oder geteilten Laserstrahl vom ersten Ablenkelement oder vom ersten Strahlteiler, vorzugsweise oder von wenigstens einem zweiten Ablenkelement oder von wenigstens einem zweiten Strahlteiler, aufzunehmen, winkelig umzulenken und parallel zueinander zu jeweils genau einer Mikro-Linse des Mikro-Linsen-Arrays zu führen.

In diesem Fall kann eine Anordnung aus Mikro-Keilen mit passenden Keilwinkeln genutzt werden, um die Winkeldivergenz für das Mikro-Linsen-Array als Fokussierelement auszugleichen, damit das Mikro-Linsen-Array eine einfache planare Geometrie aufweisen kann. Die Fokussierung in die Faserelemente erfolgt dann durch das Mikro-Linsen-Array und durch die parallel angeordneten Faserelementen des Faser-Arrays. Dabei können speziell designte Keilplatten die Komplexität der Einkopplung und der Faser-Array-Anordnung reduzieren. In jedem Fall kann es auch hier vorteilhaft sein, dass die Modendurchmesser der Einzelstrahlen bzw. der einzelnen Laserstrahlen kleiner als der Pitch der Kanäle sind.

Gemäß einem weiteren Aspekt der Erfindung ist das Fokussierelement eine Freiformoptik, wobei die Einkopplungsvorrichtung ferner eine Mehrzahl von Mikro-Keilen aufweist, welche ausgebildet und angeordnet sind, jeweils genau einen abgelenkten oder geteilten Laserstrahl vom ersten Ablenkelement oder vom ersten Strahlteiler, vorzugsweise oder von wenigstens einem zweiten Ablenkelement oder von wenigstens einem zweiten Strahlteiler, aufzunehmen, winkelig umzulenken und parallel zueinander zum Fokussierelement zu führen.

Somit kann eine Freiform-Optik verwendet werden, welche als ein Element die Winkeldivergenz ausgleichen und in das Faser-Array fokussieren kann. Die Freiform-Optik kann eine speziell designte Oberfläche sein, welche die Funktion von Keilen und Mikrolinsen in einer präzise gefertigten Phasenmaske vereinigen kann. Dadurch können beide Elemente in einem hochpräzisen Bauteil zusammengeführt werden, was die Komplexität des Aufbaus deutlich verringern kann.

Eine speziell designte Freiform-Optik kann die Winkelkorrektur und Einkopplung in die Faser-Array-Anordnung ermöglichen. Auch hier kann es vorteilhaft sein, dass die Modendurchmesser der Einzelstrahlen kleiner als der Pitch der Kanäle sind.

Jede der zuvor beschriebenen Verwendung von Mikro-Keilen, Mikro-Linsen oder Freiformoptik kann vorzugsweise zusätzlich ein Teleskop zur besseren Winkel-Aufspaltung und zur Verkleinerung der Modendurchmesser der Einzelstrahlen bzw. der einzelnen Laserstrahlen aufweisen. Dabei können für eine effiziente und kanal-getrennte Einkopplung der einzelnen Laserstrahlen in das Faser-Array die Einzelstrahlen am Ort des Faser-Arrays eine Modengröße aufweisen, welche zur Modenfeldgröße der Faserelemente passt und den richtigen Abstand der Kanäle entsprechend dem Pitch der Fasern aufweist. Zur Nutzung eines Mikro-Linsen-Arrays, von Mikro-Keilplatten oder einer Freiformoptik kann es vorteilhaft sein, falls die Modengröße der Einzelstrahlen bzw. der einzelnen Laserstrahlen kleiner als der Pitch sind und soweit aufgespalten, dass sich die Einzelstrahlen nicht überlappen. Dazu kann das Teleskop dienen und somit die mögliche Kanal-Zahl deutlich erhöhen.

Gemäß einem weiteren Aspekt der Erfindung weisen die Faserelemente des Faser-Arrays jeweils einen Modenfeldadapter auf, um genau einen abgelenkten oder geteilten Laserstrahl aufzunehmen.

Die Verwendung von Modenfeldadaptern kann die Einkopplung von Laserstrahlen mit größeren Fokusdurchmessern erlauben. Entsprechend können größere Foki der Einzelstrahlen ermöglicht werden.

Gemäß einem weiteren Aspekt der Erfindung weisen die Faserelemente des Faser-Arrays jeweils ein lichtentfernendes Element auf, welches ausgebildet ist, nicht in einen Faserkern der jeweiligen Faserelemente eingekoppeltes Laserlicht des jeweiligen abgelenkten oder geteilten Laserstrahls aus dem Faserelement, vorzugsweise aus einem Fasermantel des Faserelements, zu entfernen. Dies ebenso für eine andere lichtführende Struktur, welche alternativ oder zusätzlich vom Faserkern verwendet werden kann.

Somit können die Faserelemente des Faser-Arrays zusätzlich ein lichtentfernendes Element als sog. Cladding Light Stripper aufweisen, welches nicht im Kern befindliche Laserstrahlung filtern bzw. entfernen kann. Dies kann vorteilhaft sein, um nur im Faserkern geführtes Licht durch die Faserelemente des Faser-Arrays weiterzuleiten und zur Anwendung zu bringen, wodurch eine hohe Strahlqualität beibehalten bzw. erreicht werden kann. Bei hohen Leistungen kann ein lichtentfernendes Element besonders vorteilhaft sein, da bei schlechter Einkopplung oder beim Umschalten der Kanäle bei einem dynamischen bzw. schaltbaren Ablenkelement, vorzugsweise als diffraktives Element, Laserstrahlung im Fasermantel zu thermischen Problemen und zur Zerstörung von Faserkomponenten führen kann.

Gemäß einem weiteren Aspekt der Erfindung sind wenigstens das erste Ablenkelement oder der erste Strahlteiler, das Fokussierelement und das Faser-Array ausgebildet, den eingehenden Laserstrahl mit einer optischen Leistung von wenigstens 100 W aufzunehmen.

Dies kann die Verwendung der erfindungsgemäßen Einkopplungsvorrichtung für industrielle Anwendungen mit entsprechenden vergleichsweise hohen optischen Leistungen ermöglichen. Beispielsweise können dies Anwendungen des Laserschweißens und dergleichen sein.

Mehrere Ausführungsbeispiele und weitere Vorteile der Erfindung werden nachstehend im Zusammenhang mit den folgenden Figuren rein schematisch dargestellt und näher erläutert. Darin zeigt:
- Figur 1: eine seitliche Darstellung auf eine erfindungsgemäße Einkopplungsvorrichtung gemäß eines ersten Ausführungsbeispiels;
- Figur 2: eine Draufsicht von vorne auf ein zweidimensionales Faser-Array zur Verwendung bei allen Ausführungsbeispielen einer erfindungsgemäßen Einkopplungsvorrichtung;
- Figur 3: eine seitliche Darstellung auf eine erfindungsgemäße Einkopplungsvorrichtung gemäß eines zweiten Ausführungsbeispiels;
- Figur 4: eine seitliche Darstellung auf eine erfindungsgemäße Einkopplungsvorrichtung gemäß eines dritten Ausführungsbeispiels;
- Figur 5: eine seitliche Darstellung auf eine erfindungsgemäße Einkopplungsvorrichtung gemäß eines vierten Ausführungsbeispiels;
- Figur 6: eine seitliche Darstellung auf eine erfindungsgemäße Einkopplungsvorrichtung gemäß eines fünften Ausführungsbeispiels;
- Figur 7: eine seitliche Darstellung auf eine erfindungsgemäße Einkopplungsvorrichtung gemäß eines sechsten Ausführungsbeispiels;
- Figur 8: eine seitliche Darstellung auf eine erfindungsgemäße Einkopplungsvorrichtung gemäß eines siebten Ausführungsbeispiels;
- Figur 9: eine seitliche Darstellung auf eine erfindungsgemäße Einkopplungsvorrichtung gemäß eines achten Ausführungsbeispiels;
- Figur 10: eine seitliche Darstellung auf eine erfindungsgemäße Einkopplungsvorrichtung gemäß eines neunten Ausführungsbeispiels;
- Figur 11: eine seitliche Darstellung auf eine erfindungsgemäße Einkopplungsvorrichtung gemäß eines zehnten Ausführungsbeispiels;
- Figur 12: eine seitliche Darstellung auf eine erfindungsgemäße Einkopplungsvorrichtung gemäß eines elften Ausführungsbeispiels;
- Figur 13: eine seitliche Darstellung auf eine erfindungsgemäße Einkopplungsvorrichtung gemäß eines zwölften Ausführungsbeispiels;
- Figur 14: eine seitliche Darstellung auf eine erfindungsgemäße Einkopplungsvorrichtung gemäß eines dreizehnten Ausführungsbeispiels;
- Figur 15: eine seitliche Darstellung auf ein Ende eines Faserelements gemäß einer ersten Variante einer erfindungsgemäßen Einkopplungsvorrichtung gemäß einem der Ausführungsbeispiele; und
- Figur 16: eine seitliche Darstellung auf ein Ende eines Faserelements gemäß einer zweiten Variante einer erfindungsgemäßen Einkopplungsvorrichtung gemäß einem der Ausführungsbeispiele.

Die o.g. Figuren werden in kartesischen Koordinaten betrachtet. Es erstreckt sich eine Längsachse X, welche auch als Tiefe X oder als Länge X bezeichnet werden kann. Senkrecht zur Längsachse X erstreckt sich eine Querachse Y, welche auch als Breite Y bezeichnet werden kann. Senkrecht sowohl zur Längsachse X als auch zur Querachse Y erstreckt sich eine vertikale Achse Z, welche auch als Höhe Z bezeichnet werden kann und der Richtung der Schwerkraft bzw. der Gravitationskraft entspricht. Die Längsachse X und die Querachse Y bilden gemeinsam die Horizontale X, Y, welche auch als horizontale Ebene X, Y bezeichnet werden kann.

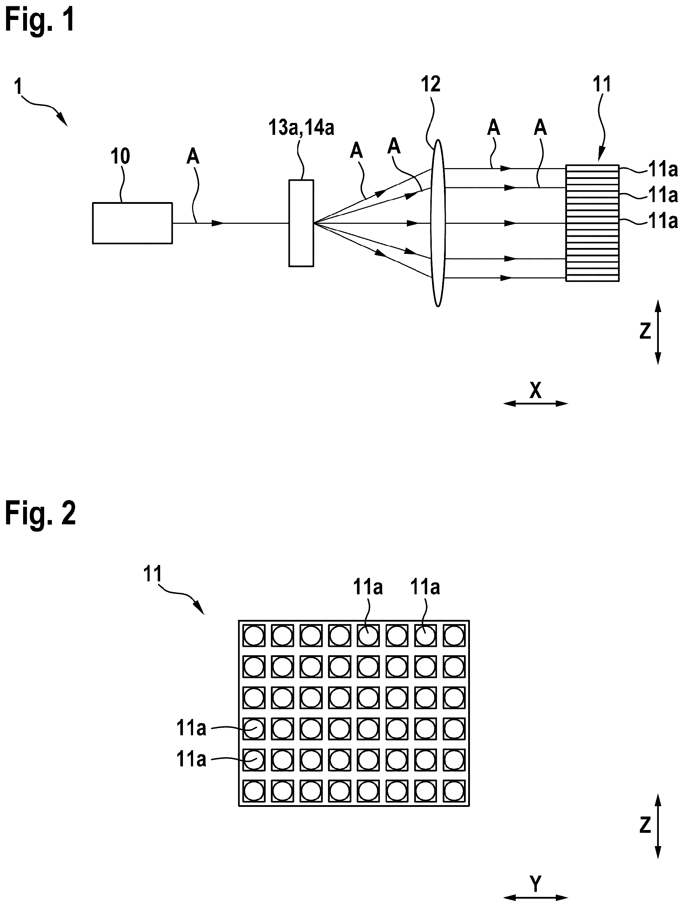

Figur 1 zeigt eine seitliche Darstellung auf eine erfindungsgemäße Einkopplungsvorrichtung 1 gemäß eines ersten Ausführungsbeispiels. Figur 2 zeigt eine Draufsicht von vorne auf ein zweidimensionales Faser-Array 11 zur Verwendung bei allen Ausführungsbeispielen einer erfindungsgemäßen Einkopplungsvorrichtung 1.

Es ist eine Laserstrahlquelle 10 vorhanden, welche ein Bestandteil der erfindungsgemäßen Einkopplungsvorrichtungen 1 sein kann oder auch nicht, d.h. außerhalb der erfindungsgemäßen Einkopplungsvorichtungen 1 angeordnet sein kann. Die Laserquelle 10 kann einen Laserstrahl A erzeugen oder auch einen Laserstrahl A aufnehmen und weiterleiten sowie ggfs. verstärken. Der Laserstrahl A kann auch als Laserlichtstrahlung A bezeichnet werden.

In jedem Fall erreicht der Laserstrahl A im Falle der erfindungsgemäßen Einkopplungsvorrichtung 1 gemäß eines ersten Ausführungsbeispiels entweder ein erstes Ablenkelement 13a, welches ein erster akustooptischer Modulator (AOM) 13a sein kann. In diesem Fall wird der eingehende Laserstrahl A in mehrere ausgehende Laserstrahlen A zweidimensional aufgeteilt, was zeitlich versetzt bzw. hintereinander und somit alternativ zueinander erfolgen kann (nicht dargestellt), was als zeitlich dynamisch bezeichnet werden kann, wobei jeder der ausgehenden Laserstrahlen A etwa die gleiche optische Leistung aufweist wie der eingehende Laserstrahl A. Alternativ kann der erste akustooptische Modulator 13a den eingehenden Laserstrahl A auch in mehrere parallele und gleichzeitig austretende Laserstrahlen A aufteilen, vgl. Figur 1, was als zeitlich statisch bezeichnet werden kann. Dies kann alternativ auch mittels eines ersten Strahlteilers 14a in Form eines ersten diffraktiven optischen Elements (DOE) 14a erfolgen.

In jedem Fall erreichen die zeitlich versetzt oder zeitgleich sternförmig austretenden Laserstahlen A anschließend ein Fokussierelement 12, welches bei der erfindungsgemäßen Einkopplungsvorrichtung 1 gemäß des ersten Ausführungsbeispiels als Linse 12 realisiert ist, alternativ aber auch ein Mikro-Linsen-Array 12, ein Hohlspiegel 12, ein Paraboloid 12 oder eine Freiformoptik 12 sein kann, wie teilweise anhand einem der nachfolgenden Ausführungsbeispiele noch beschrieben werden wird. Dabei werden die Laserstahlen A jeweils mittels der Linse 12 fokussiert und parallel zueinander ausgerichtet sowie jeweils auf ein Faserelement 11a eines Faser-Arrays 11 hin gerichtet, um in das jeweilige Faserelement 11 einzutreten. Die Faserelemente 11a können auch als Lichtleitfasern 11a bezeichnet werden.

Die Faserelemente 11a des Faser-Arrays 11 leiten die aufgenommenen Laserstrahlen A von demjenigen Ende (nicht bezeichnet), in welches die Laserstrahlen A eintreten, zum gegenüberliegenden Ende (nicht dargestellt) weiter, um dort in einer gewünschten Anordnung auszutreten und beispielsweise im Rahmen einer Anwendung des Laserschweißens auf einen Körper zu wirken, um diesen zu schweißen. Hierzu können entsprechend hohe Leistungen von beispielsweise 100 W des eingehenden Laserstrahls A verwendet werden. Die Faserelemente 11a des Faser-Arrays 11 können hierzu vorzugsweise zweidimensional rechteckig angeordnet sein, siehe Figur 2.

Das erste Ausführungsbeispiel einer erfindungsgemäßen Einkopplungsvorrichtung 1 weist dabei lediglich eine Ebene eines ersten zeitlich statischen oder zeitlich dynamischen Ablenkelements 13a oder eines ersten Strahlteilers 14a auf, welche auch als drei einzelne Ausführungsbeispiele angesehen werden können, jedoch aufgrund ihrer Gemeinsamkeit, dass zwischen der Laserquelle 10 und dem Fokussierelement 12 lediglich ein erstes Ablenkelement 13a oder ein erster Strahlteiler 14a vorhanden ist, durch die Figur 1 dargestellt werden können.

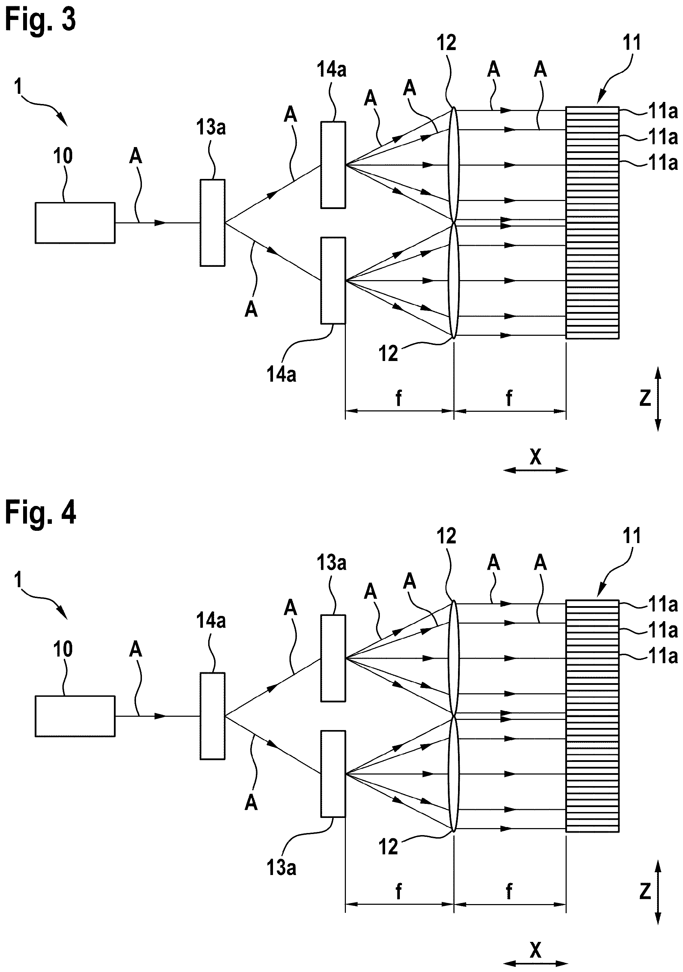

Figur 3 zeigt eine seitliche Darstellung auf eine erfindungsgemäße Einkopplungsvorrichtung 1 gemäß eines zweiten Ausführungsbeispiels.

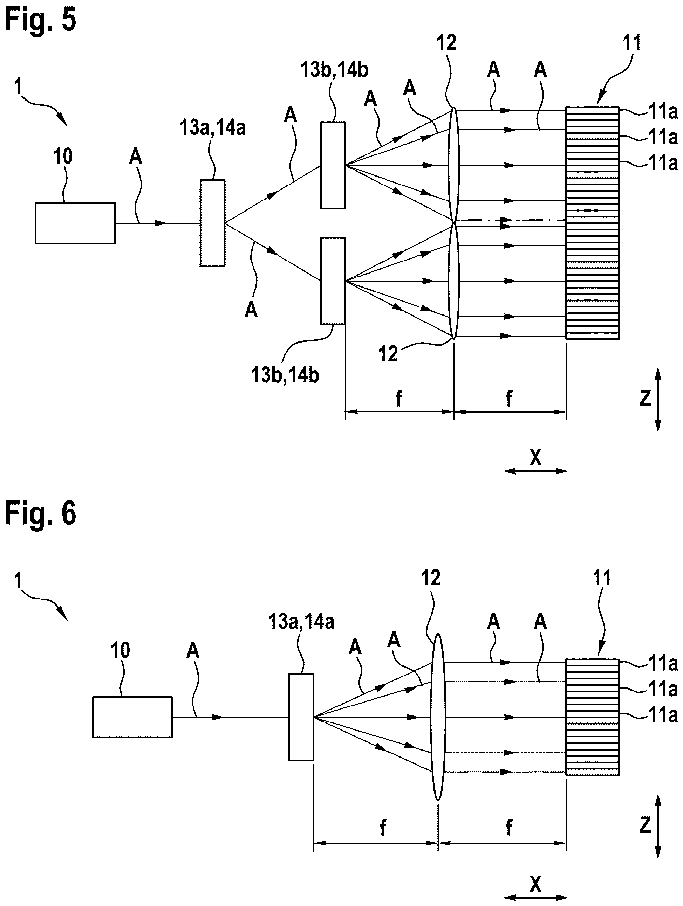

In diesem Fall findet eine Ablenkung bzw. eine Strahlteilung in zwei Ebenen statt, indem die ausgehenden Laserstrahlen A des ersten Ablenkelements 13a jeweils einen ersten Strahlteiler 14a erreichen und dort jeweils mehrfach aufgeteilt werden. Dabei ist pro erstem Strahlteiler 14a ein Fokussierelement 12 wie zuvor beschrieben vorhanden, um die Laserstrahlen A in ein entsprechend großes Faser-Array 11 einzukoppeln, wie zuvor beschrieben. Auch ist das Fokussierelement 12 im Abstand seiner Brennweite f zum ersten Ablenkelement 13a bzw. zum ersten Strahlteiler 14a angeordnet und das Faser-Array 11 ist im Abstand der Brennweite f des Fokussierelements 12 zum Fokussierelement 12 angeordnet, wie anhand des fünften Ausführungsbeispiels der Figur 6 näher beschrieben werden wird.

Figur 4 zeigt eine seitliche Darstellung auf eine erfindungsgemäße Einkopplungsvorrichtung 1 gemäß eines dritten Ausführungsbeispiels.

In diesem Fall erreicht der Laserstrahl A nach der Laserquelle 10 zunächst einen ersten Strahlteiler 14a als erste Ebene und von dort mehrere erste zeitlich statische oder zeitlich dynamische Ablenkelemente 13a als zweite Ebene. Es schließt sich das Fokussierelement 12 wie zuvor beschrieben an.

Figur 5 zeigt eine seitliche Darstellung auf eine erfindungsgemäße Einkopplungsvorrichtung 1 gemäß eines vierten Ausführungsbeispiels.

Es wird die Möglichkeit dargestellt, um entweder ein erstes zeitlich statisches oder zeitlich dynamisches Ablenkelement 13a in der ersten Ebene mit mehreren zweiten zeitlich statischen oder zeitlich dynamischen Ablenkelementen 13b in der zweiten Ebene zu kombinieren oder einen ersten Strahlteiler 14a in der ersten Ebene mit mehreren zweiten Strahlteilern 14b in der zweiten Ebene.

Figur 6 zeigt eine seitliche Darstellung auf eine erfindungsgemäße Einkopplungsvorrichtung 1 gemäß eines fünften Ausführungsbeispiels.

Die Anordnung des fünften Ausführungsbeispiels der Figur 6 entspricht dem ersten Ausführungsbeispiel der Figur 1 mit der Konkretisierung, dass das Fokussierelement 12 im Abstand seiner Brennweite f zum ersten Ablenkelement 13a bzw. zum ersten Strahlteiler 14a angeordnet ist. Ebenso ist das Faser-Array 11 im Abstand der Brennweite f des Fokussierelements 12 zum Fokussierelement 12 angeordnet. Hierdurch kann die Winkeldivergenz des ersten Ablenkelements 13a korrigiert werden und die einzelnen Strahl-Größen der einzelnen Laserstrahlen A können in der Fourier-Ebene fokussiert können, wo das Faser-Array 11 angeordnet ist.

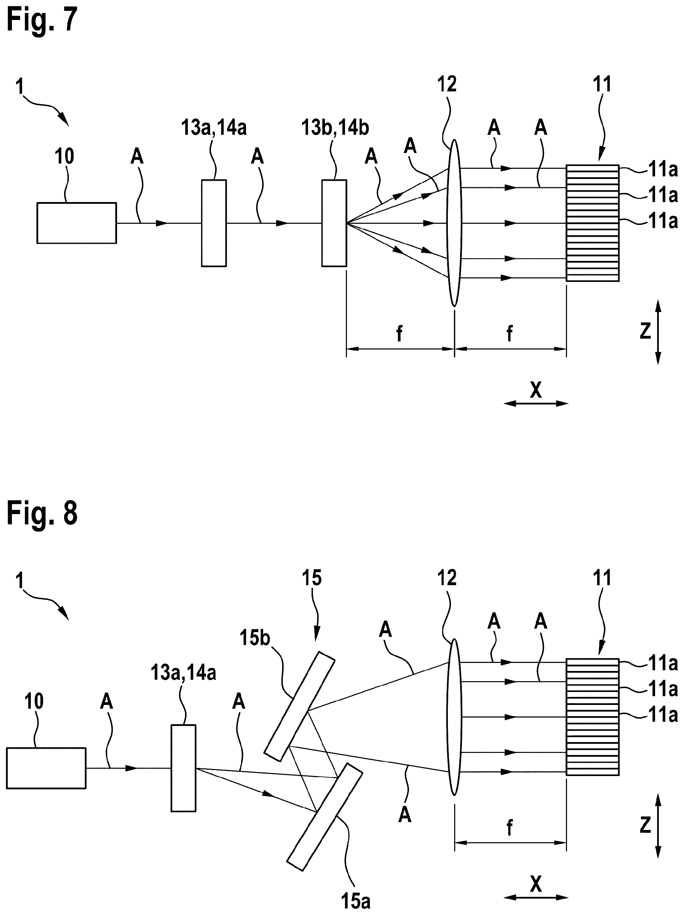

Figur 7 zeigt eine seitliche Darstellung auf eine erfindungsgemäße Einkopplungsvorrichtung 1 gemäß eines sechsten Ausführungsbeispiels.

In diesem Fall sind entweder das erste Ablenkelement 13a in der ersten Ebene und ein zweites Ablenkelement 13b in der zweiten Ebene angeordnet oder es ist ein erster Strahlteiler 14a in der ersten Ebene und ein zweiter Strahlteiler 14b in der zweiten Ebene angeordnet. Die Ablenkelemente 13a, 13b oder die Strahlteiler 14a, 14b sind dabei jeweils eindimensional ablenkend bzw. teilend ausgebildet, so dass in der ersten Ebene jeweils eine Ablenkung bzw. Teilung entlang der Querachse Y und anschließend in der zweiten Ebene jeweils eine Ablenkung bzw. Teilung entlang der vertikalen Achse Z erfolgt. Dies kann die Umsetzung der Ablenkelemente 13a, 13b bzw. der Strahlteiler 14a, 14b vereinfachen, da diese jeweils lediglich eindimensional wirkend ausgebildet sein müssen.

Zusätzlich wird die Anordnung des Fokussierelements 12 im Abstand seiner Brennweite f zum zweiten Ablenkelement 13b bzw. zum zweiten Strahlteiler 14b in Kombination der Anordnung des Faser-Arrays 11 im Abstand der Brennweite f des Fokussierelements 12 zum Fokussierelement 12 genutzt, um die entsprechende zuvor beschrieben Fokussierung zu erreichen.

Figur 8 zeigt eine seitliche Darstellung auf eine erfindungsgemäße Einkopplungsvorrichtung 1 gemäß eines siebten Ausführungsbeispiels.

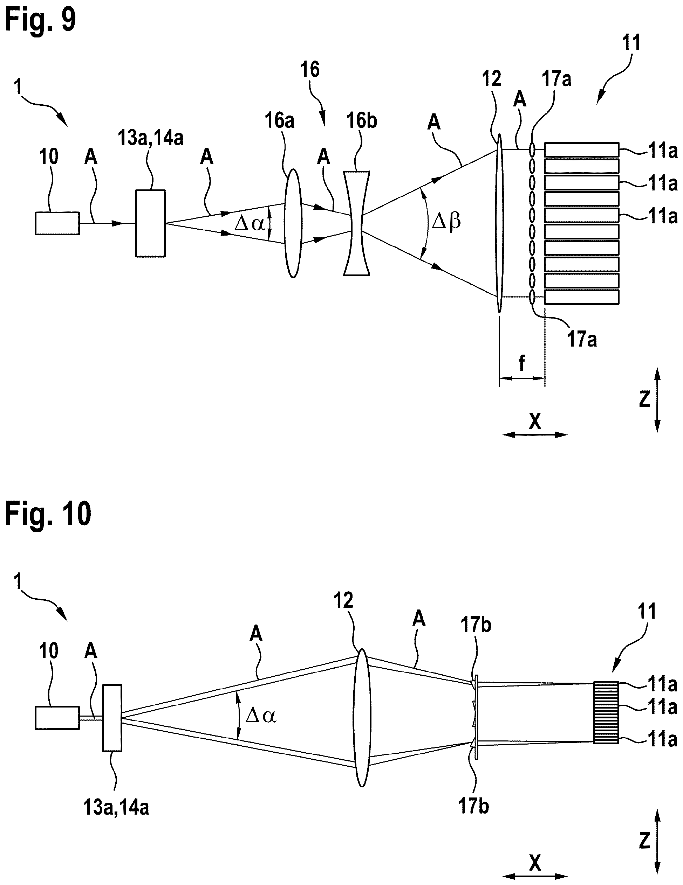

In diesem Fall wird eine Vergrößerungsvorrichtung 15 in Form einer Spiegelstrecke 15 mit einem ersten Umlenkspiegel 15a und mit einem zweiten Umlenkspiegel 15b oder einer Abbildungsoptik 15 dazu verwendet, die abgelenkten oder geteilten Laserstrahlen A vom ersten Ablenkelement 13a oder vom ersten Strahlteiler 14a aufzunehmen und zum Fokussierelement 12 zu führen und dabei in ihrem Abstand zueinander zu vergrößern. Die Spiegelstrecke 15 kann dazu dienen, auf vergleichsweise kompaktem Bauraum die vollständige Trennung der einzelnen Moden zu erreichen, damit diese separat, beispielsweise mit zusätzlichen Mikro-Linsen 17a, vgl. Figur 9, fokussiert werden können. Hierdurch kann der Abstand der Faserelemente 11a des Faser-Arrays 11 zueinander vergrößert werden, um in eine entsprechende Anordnung von Faserelementen 11a des Faser-Arrays 11 eingekoppelt zu werden.

Figur 9 zeigt eine seitliche Darstellung auf eine erfindungsgemäße Einkopplungsvorrichtung 1 gemäß eines achten Ausführungsbeispiels.

In diesem Fall wird eine Teleskopvorrichtung 16 mit einer Linse 16a und mit einem Okular 16b verwendet, um die abgelenkten oder geteilten Laserstrahlen A vom ersten Ablenkelement 13a oder vom ersten Strahlteiler 14a aufzunehmen und zum Fokussierelement 12 zu führen und dabei ihre Winkelaufweitung zu vergrößern sowie die Strahlgröße zu verkleinern. Dabei treten die Laserstrahlen A in einem ersten Winkel Δ α in die Linse 16a der Teleskopvorrichtung 16 ein und in einem zweiten, größeren Winkel Δ β aus dem Okular 16b wieder aus, um anschließend in das Fokussierelement 12 einzutreten und dort fokussiert zu werden. Zwischen dem Fokussierelement 12 und dem Faser-Array 11 ist pro Laserstrahl A eine Mikro-Linse 17a vorgesehen, um eine weitere Fokussierung zum jeweiligen Faserelement 11a hin zu erreichen. Hierdurch kann eine Vergrößerung der Winkelaufweitung bei gleichzeitiger Verkleinerung der Strahlgrößen der Laserstrahlen A erreicht werden.

Figur 10 zeigt eine seitliche Darstellung auf eine erfindungsgemäße Einkopplungsvorrichtung 1 gemäß eines neunten Ausführungsbeispiels.

In diesem Fall ist das Fokussierelement 12 in einem Abstand unterhalb seiner Brennweite f zum ersten Ablenkelement 13a oder zum ersten Strahlteiler 14a angeordnet. Ferner ist eine Mehrzahl von Mikro-Keilen 17b vorgesehen, welche ausgebildet und angeordnet sind, jeweils genau einen abgelenkten oder geteilten Laserstrahl A vom Fokussierelement 12 aufzunehmen und jeweils zu genau eines der Faserelemente 11a des Faser-Arrays 11 zu führen. Die Mikro-Keile 17b werden mit passenden Keilwinkeln genutzt, um die Winkeldivergenz des Fokussierelements 12 auszugleichen.

Diese Anordnung erlaubt die Verwendung von Fokussierelementen 12 mit vergleichsweise kurzer Brennweite, was die Gestaltungsmöglichkeiten für die notwendige Fokussierung auf die Faserelemente 11a erweitern kann. Die zu erreichenden Strahlradien können hier für Single-Mode oder LMA Fasern im Bereich 3 µm bis 15 µm liegen. Der auszufüllenden Raumbereich gegeben durch den Pitch-Abstand des Faser-Arrays 11 und der Kanalzahl, kombiniert mit kleinen Aufspaltwinkeln der Ablenkelemente 13a macht in einer einfachen Anordnung langbrennweitige Fokussierelemente notwendig, die nicht geeignet sind, diese kleine Strahlradien an der Einkoppelstelle zu erreichen. Diese Verknüpfung von Geometrie und Fokusgröße wird durch das Ausführungsbeispiel aufgehoben.

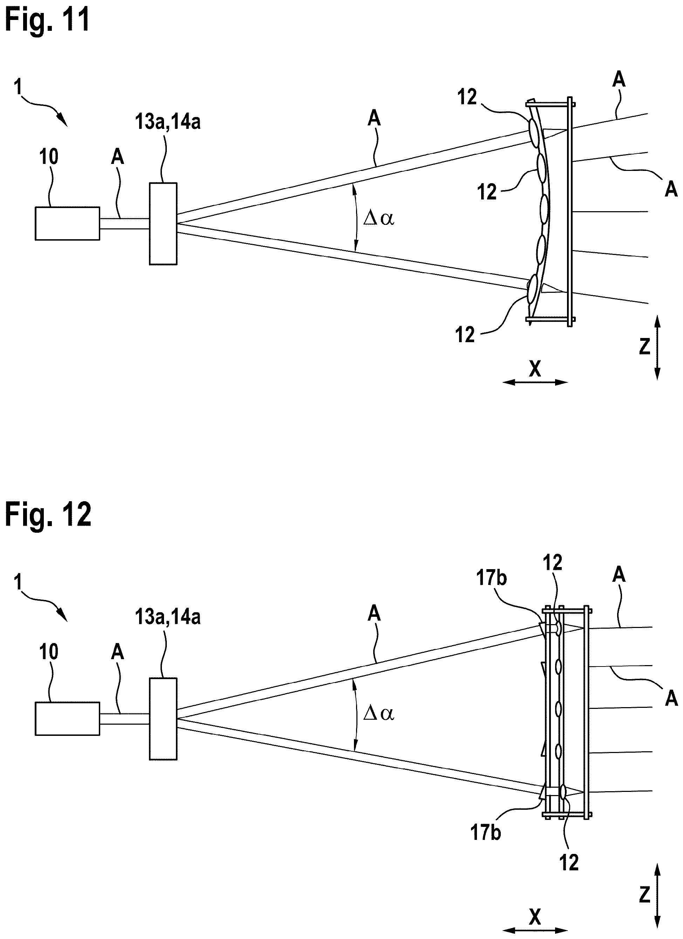

Figur 11 zeigt eine seitliche Darstellung auf eine erfindungsgemäße Einkopplungsvorrichtung 1 gemäß eines zehnten Ausführungsbeispiels.

In diesem Fall ist das Fokussierelement 12 ein Mikro-Linsen-Array 12, wobei die Mikro-Linsen des Mirko-Linsen-Arrays 12 gemeinsam eine gekrümmte Oberfläche bilden, welche ausgebildet ist, die abgelenkten oder geteilten Laserstrahlen A jeweils von genau einer Mikro-Linsen des Mikro-Linsen-Arrays 12 geradlinig aufzunehmen und geradlinig zum Fokussierelement 12 zu führen. Dies führt zu einer sternförmigen Ausbreitung der Laserstrahlen A, so dass die Faserelemente 11a (nicht dargestellt) entsprechend angeordnet und ausgerichtet sind, um die Laserstrahlen A geradlinig einzukoppeln.

Figur 12 zeigt eine seitliche Darstellung auf eine erfindungsgemäße Einkopplungsvorrichtung 1 gemäß eines elften Ausführungsbeispiels.

Auch in diesem Fall ist das Fokussierelement 12 ein Mikro-Linsen-Array 12. Ferner ist eine Mehrzahl von Mikro-Keilen 17b vorgesehen, welche ausgebildet und angeordnet sind, jeweils genau einen abgelenkten oder geteilten Laserstrahl A vom ersten Ablenkelement 13a oder vom ersten Strahlteiler 14a aufzunehmen, winkelig umzulenken und parallel zueinander zu jeweils genau einer Mikro-Linse des Mikro-Linsen-Arrays 12 zu führen. Mittels der Anordnung aus Mikro-17b Keilen mit passenden Keilwinkeln kann die Winkeldivergenz des Mikro-Linsen-Arrays 12 als Fokussierelement 12 ausgeglichen werden. Die Fokussierung in die Faserelemente 11a erfolgt dann durch das in einfacher Geometrie plan angeordnete Mikro-Linsen-Array 12 und durch die parallel angeordneten Faserelemente 11a des Faser-Arrays 11.

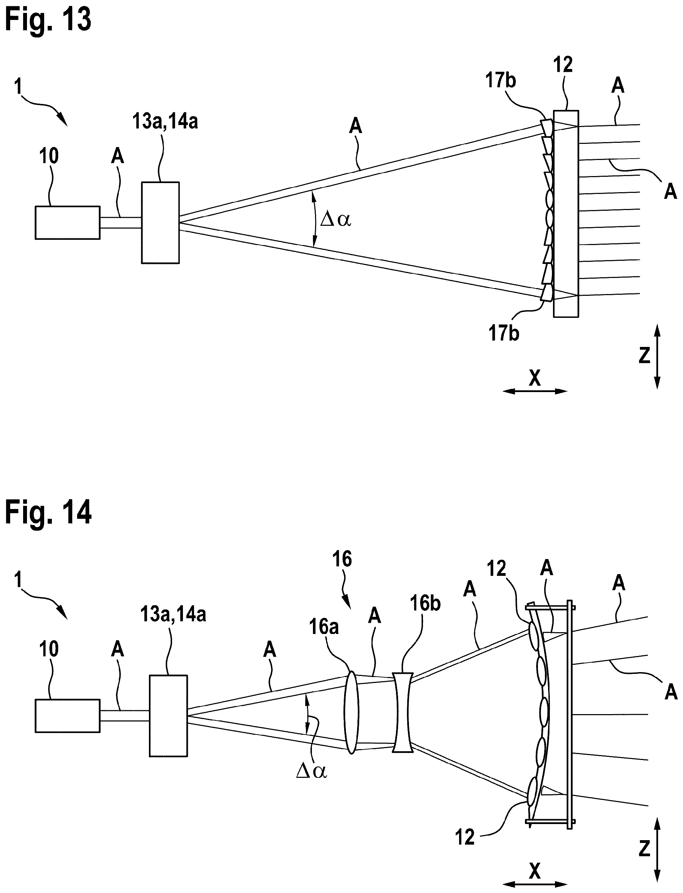

Figur 13 zeigt eine seitliche Darstellung auf eine erfindungsgemäße Einkopplungsvorrichtung 1 gemäß eines zwölften Ausführungsbeispiels.

In diesem Fall ist das Fokussierelement 12 eine Freiformoptik 12, welche ausgebildet ist, die Funktion von Keilen und Mikrolinsen in einer präzise gefertigten Phasenmaske zu vereinigen. Dadurch werden beide Elemente in einem hochpräzisen Bauteil zusammengeführt, was die Komplexität des Aufbaus deutlich verringert. Ferner ist eine Mehrzahl von Mikro-Keilen 17b vorgesehen, welche ausgebildet und angeordnet sind, jeweils genau einen abgelenkten oder geteilten Laserstrahl A vom ersten Ablenkelement 13a oder vom ersten Strahlteiler 14a aufzunehmen, winkelig umzulenken und parallel zueinander zum Fokussierelement 12 zu führen. Somit kann eine Freiform-Optik 12 verwendet werden, welche als ein Element die Winkeldivergenz ausgleichen und in das Faser-Array 11 fokussieren kann.

Figur 14 zeigt eine seitliche Darstellung auf eine erfindungsgemäße Einkopplungsvorrichtung 1 gemäß eines dreizehnten Ausführungsbeispiels.

In diesem Fall wird das Fokussierelement 12 der Figur 11 bzw. des zehnten Ausführungsbeispiels als Mikro-Linsen-Array 12, dessen Mikro-Linsen gemeinsam eine gekrümmte Oberfläche bilden, und die Teleskopvorrichtung 16 mit einer Linse 16a und mit einem Okular 16b der Figur 9 bzw. des achten Ausführungsbeispiels miteinander kombiniert.

Diese Kombination ist ebenfalls mit dem Fokussierelement 12 gemäß des elften Ausführungsbeispiels der Figur 12 sowie mit dem zwölften Ausführungsbeispiel der Figur 13 in gleicher Weise denkbar.

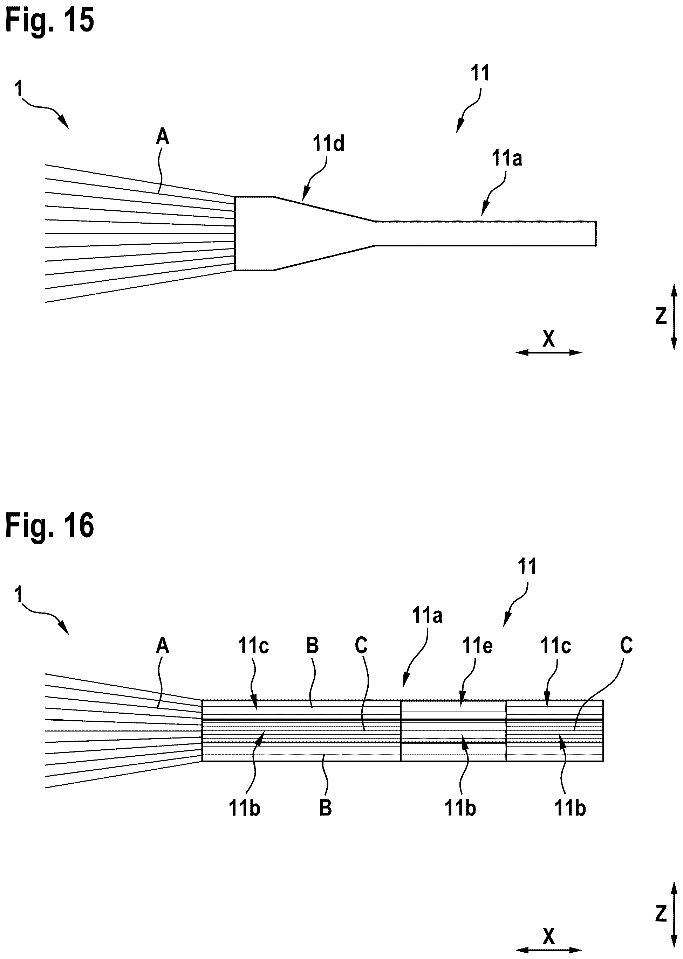

Figur 15 zeigt eine seitliche Darstellung auf ein Ende eines Faserelements 11a gemäß einer ersten Variante einer erfindungsgemäßen Einkopplungsvorrichtung 1 gemäß einem der Ausführungsbeispiele.

Die Faserelemente 11a des Faser-Arrays 11 weisen jeweils einen Modenfeldadapter 11d auf, um genau einen abgelenkten oder geteilten Laserstrahl A aufzunehmen. Dies kann die Einkopplung von Laserstrahlen A mit größeren Fokusdurchmessern erlauben. Entsprechend können größere Foki der Laserstrahlen A ermöglicht werden.

Zu beachten ist hinsichtlich der Darstellung des Laserstrahls A der Figuren 15 und 16, dass die einzelnen durchgezogenen Linien der Figuren 15 und 16, welche mit dem Bezugszeichen A versehen sind, Teilstrahlen eines einzigen Laserstrahls A sind, welche gemeinsam in das jeweils gezeigte eine Faserelement 11a des Faser-Arrays 11 eingekoppelt werden.

Figur 16 zeigt eine seitliche Darstellung auf ein Ende eines Faserelements 11a gemäß einer zweiten Variante einer erfindungsgemäßen Einkopplungsvorrichtung 1 gemäß einem der Ausführungsbeispiele.

In diesem Fall weisen die Faserelemente 11a des Faser-Arrays 11 jeweils ein lichtentfernendes Element 11e auf, welches ausgebildet ist, nicht in einen Faserkern 11b des jeweiligen Faserelementes 11a eingekoppeltes Laserlicht als Mantellichtstrahlung B des jeweiligen abgelenkten oder geteilten Laserstrahls A aus einem Fasermantel 11c des Faserelementes 11a zu entfernen. Entsprechend breitet ist lediglich derjenige Teil des jeweiligen Laserstrahls A, welcher sich als Kernlichtstrahlung C im Faserkern 11b befindet, weiter entlang des Faserelements 11a aus.

Somit kann nicht im Faserkern 11b befindliche Laserstrahlung A mittels des lichtentfernenden Elements 11e aus dem jeweiligen Faserelement 11a des Faser-Arrays 11 gefiltert bzw. entfernt werden kann, wodurch eine hohe Strahlqualität beibehalten bzw. erreicht werden kann.

Für hohe Leistungen im Bereich 100 W oder mehr ist dies besonders vorteilhaft, um eine Zerstörung der Faser-Elemente 11a zu vermeiden. Insbesondere sind die lichtentfernenden Elemente 11e der Faserelemente 11a des Faser-Arrays 11 auch für diesen hohen Leistungsbereich geeignet.

### BEZUGSZEICHENLISTE (Teil der Beschreibung)

- Δ α: erster Winkel
- Δ β: zweiter Winkel
- A: Laserstrahlen; Laserlichtstrahlung
- B: Mantellichtstrahlung
- C: Kernlichtstrahlung
- f: Brennweite
- X: Längsachse; Tiefe; Länge
- Y: Querachse; Breite
- Z: vertikale Achse; Höhe
- X, Y: Horizontale; horizontale Ebene

- 1: Einkopplungsvorrichtung
- 10: Laserstrahlquelle
- 11: Faser-Array
- 11a: Faserelemente bzw. Lichtleitfasern des Faser-Arrays 11
- 11b: Faserkerne des Faser-Arrays 11
- 11c: Fasermäntel des Faser-Arrays 11
- 11d: Modenfeldadapter des Faser-Arrays 11
- 11e: lichtentfernendes Element; Cladding Light Stripper
- 12: Fokussierelement; Linse; Mikro-Linsen-Array; Hohlspiegel; Paraboloid; Freiformoptik
- 13a: erstes Ablenkelement; erster akustooptischer Modulator (AOM)
- 13b: zweite Ablenkelemente; zweite akustooptische Modulatoren (AOM)
- 14a: erster Strahlteiler; erstes diffraktives optisches Element (DOE)
- 14b: zweite Strahlteiler; zweite diffraktive optische Elemente (DOE)
- 15: Vergrößerungsvorrichtung; Spiegelstrecke; Abbildungsoptik
- 15a: erster Umlenkspiegel der Vergrößerungsvorrichtung 15 bzw. Spiegelstrecke 15
- 15b: zweiter Umlenkspiegel der Vergrößerungsvorrichtung 15 bzw. Spiegelstrecke 15
- 16: Teleskopvorrichtung
- 16a: Linse bzw. Hohlspiegel der Teleskopvorrichtung 16
- 16b: Okular der Teleskopvorrichtung 16
- 17a: Mikro-Linsen
- 17b: Mikro-Keile

## Patentansprüche

1. Einkopplungsvorrichtung (1) zum Einkoppeln wenigstens eines Laserstrahls (A) in wenigstens ein Faser-Array (11) mit
wenigstens einem ersten Ablenkelement (13a) oder wenigstens einem ersten Strahlteiler (14a), welches/welcher ausgebildet und angeordnet ist, den Laserstrahl (A) aufzunehmen und mehrfach abzulenken oder zu teilen,
wenigstens einem Fokussierelement (12), welches ausgebildet und angeordnet ist, die abgelenkten oder geteilten Laserstrahlen (A) aufzunehmen und zu fokussieren, und
wenigstens dem Faser-Array (11), welches eine Mehrzahl von wenigstens eindimensional, vorzugsweise zweidimensional, zueinander angeordneten Faserelementen (11a) aufweist.

2. Einkopplungsvorrichtung (1) nach Anspruch 1,
mit wenigstens dem ersten Ablenkelement (13a), welches ausgebildet und angeordnet ist, den Laserstrahl (A) aufzunehmen und mehrfach abzulenken, und
ferner mit wenigstens einem ersten Strahlteiler (14a), welcher ausgebildet und angeordnet ist, einen der abgelenkten Laserstrahlen (A) aufzunehmen und zum Fokussierelement (12) zu teilen,
vorzugsweise ferner mit wenigstens zwei ersten Strahlteilern (14a), welche ausgebildet und angeordnet sind, jeweils einen der abgelenkten Laserstrahlen (A) aufzunehmen und zum Fokussierelement (12) zu teilen, oder
vorzugsweise ferner mit wenigstens einem zweiten Ablenkelement (13b), welches ausgebildet und angeordnet ist, den anderen der abgelenkten Laserstrahlen (A) aufzunehmen und zum Fokussierelement (12) mehrfach abzulenken.

3. Einkopplungsvorrichtung (1) nach Anspruch 1,
mit wenigstens dem ersten Strahlteiler (14a), welcher ausgebildet und angeordnet ist, den Laserstrahl (A) aufzunehmen und zu teilen, und
ferner mit wenigstens einem ersten Ablenkelement (13a), welcher ausgebildet und angeordnet ist, einen der geteilten Laserstrahlen (A) aufzunehmen und zum Fokussierelement (12) mehrfach abzulenken,
vorzugsweise ferner mit wenigstens zwei ersten Ablenkelementen (13a), welche ausgebildet und angeordnet sind, jeweils einen der geteilten Laserstrahlen (A) aufzunehmen und zum Fokussierelement (12) mehrfach abzulenken, oder
vorzugsweise ferner mit wenigstens einem zweiten Strahlteiler (14b), welcher ausgebildet und angeordnet ist, den anderen der geteilten Laserstrahlen (A) aufzunehmen und zum Fokussierelement (12) zu teilen.

4. Einkopplungsvorrichtung (1) nach Anspruch 1,
mit dem ersten Ablenkelement (13a), welches ausgebildet und angeordnet ist, den Laserstrahl (A) aufzunehmen und mehrfach abzulenken, und
ferner mit wenigstens zwei zweiten Ablenkelementen (13b), welche ausgebildet und angeordnet sind, jeweils einen der abgelenkten Laserstrahlen (A) vom ersten Ablenkelement (13a) aufzunehmen und zum Fokussierelement (12) mehrfach abzulenken.

5. Einkopplungsvorrichtung (1) nach Anspruch 1,
mit dem ersten Strahlteiler (14a), welcher ausgebildet und angeordnet ist, den Laserstrahl (A) aufzunehmen und zu teilen, und
ferner mit zwei zweiten Strahlteilern (14b), welche ausgebildet und angeordnet sind, jeweils einen der geteilten Laserstrahlen (A) vom ersten Strahlteiler (14a) aufzunehmen und zum Fokussierelement (12) zu teilen.

6. Einkopplungsvorrichtung (1) nach einem der vorangehenden Ansprüche,
wobei das erste Ablenkelement (13a) ein erster akustooptischer Modulator (13a), vorzugsweise und ein zweites Ablenkelement (13b) ein zweiter akustooptischer Modulator (13b), ist, und/oder
wobei das erste Ablenkelement (13a), vorzugsweise und ein zweites Ablenkelement (13b), ausgebildet ist, den Laserstrahl (A) eindimensional oder zweidimensional abzulenken, und/oder
wobei der erste Strahlteiler (14a) ein erstes diffraktives optisches Element (14a), vorzugweise und ein zweiter Strahlteiler (14b) ein zweites diffraktives optisches Element (14b), ist, und/oder
wobei der erste Strahlteiler (14a), vorzugweise und ein zweiter Strahlteiler (14b), ausgebildet ist, den Laserstrahl (A) eindimensional oder zweidimensional zu teilen, und/oder
wobei das Fokussierelement (12) eine Linse (12), ein Mikro-Linsen-Array (12), ein Hohlspiegel (12), ein Paraboloid (12) oder eine Freiformoptik (12) ist.

7. Einkopplungsvorrichtung (1) nach einem der vorangehenden Ansprüche,
wobei das Fokussierelement (12) im Abstand seiner Brennweite (f) zum ersten Ablenkelement (13a) oder zum ersten Strahlteiler (14a), vorzugsweise oder zu wenigstens einem zweiten Ablenkelement (13b) oder zu wenigstens einem zweiten Strahlteiler (14b), angeordnet ist und
wobei das Faser-Array (11) im Abstand der Brennweite (f) des Fokussierelements (12) zum Fokussierelement (12) angeordnet ist.

8. Einkopplungsvorrichtung (1) nach einem der vorangehenden Ansprüche,
ferner mit wenigstens einer Vergrößerungsvorrichtung (15), vorzugsweise mit wenigstens einer Spiegelstrecke (15) oder einer Abbildungsoptik (15), welche ausgebildet und angeordnet ist, die abgelenkten oder geteilten Laserstrahlen (A) vom ersten Ablenkelement (13a) oder vom ersten Strahlteiler (14a), vorzugsweise oder von wenigstens einem zweiten Ablenkelement (13b) oder von wenigstens einem zweiten Strahlteiler (14b), aufzunehmen und zum Fokussierelement (12) zu führen und dabei in ihrem Abstand zueinander zu vergrößern.

9. Einkopplungsvorrichtung (1) nach einem der vorangehenden Ansprüche,
ferner mit wenigstens einer Teleskopvorrichtung (16), welche ausgebildet und angeordnet ist, die abgelenkten oder geteilten Laserstrahlen (A) vom ersten Ablenkelement (13a) oder vom ersten Strahlteiler (14a), vorzugsweise oder von wenigstens einem zweiten Ablenkelement (13b) oder von wenigstens einem zweiten Strahlteiler (14b), aufzunehmen und zum Fokussierelement (12) zu führen und dabei ihre Winkelaufweitung zu vergrößern sowie die Strahlgröße zu verkleinern.

10. Einkopplungsvorrichtung (1) nach einem der vorangehenden Ansprüche,
ferner mit einer Mehrzahl von Mikro-Linsen (17a), welche ausgebildet und angeordnet sind, jeweils genau einen abgelenkten oder geteilten Laserstrahl (A) vom Fokussierelement (12) aufzunehmen und jeweils zu genau eines der Faserelemente (11a) des Faser-Arrays (11) zu führen und dabei weiter zu fokussieren.

11. Einkopplungsvorrichtung (1) nach einem der Ansprüche 1 bis 8,
wobei das Fokussierelement (12) in einem Abstand unterhalb seiner Brennweite (f) zum ersten Ablenkelement (13a) oder zum ersten Strahlteiler (14a), vorzugsweise oder zu einem zweiten Ablenkelement (13b) oder zu einem zweiten Strahlteiler (14b), angeordnet ist,
ferner mit einer Mehrzahl von Mikro-Keilen (17b), welche ausgebildet und angeordnet sind, jeweils genau einen abgelenkten oder geteilten Laserstrahl (A) vom Fokussierelement (12) aufzunehmen und jeweils zu genau eines der Faserelemente (11a) des Faser-Arrays (11) zu führen.

12. Einkopplungsvorrichtung (1) nach einem der vorangehenden Ansprüche,
wobei das Fokussierelement (12) ein Mikro-Linsen-Array (12) ist,
wobei die Mikro-Linsen des Mirko-Linsen-Arrays (12) gemeinsam eine gekrümmte Oberfläche bilden, welche ausgebildet ist, die abgelenkten oder geteilten Laserstrahl (A) jeweils von genau einer Mikro-Linsen des Mikro-Linsen-Arrays (12) geradlinig aufzunehmen und geradlinig zum Fokussierelement (12) zu führen.

13. Einkopplungsvorrichtung (1) nach einem der Ansprüche 1 bis 10,
wobei das Fokussierelement (12) ein Mikro-Linsen-Array (12) ist,
ferner mit einer Mehrzahl von Mikro-Keilen (17b), welche ausgebildet und angeordnet sind, jeweils genau einen abgelenkten oder geteilten Laserstrahl (A) vom ersten Ablenkelement (13a) oder vom ersten Strahlteiler (14a), vorzugsweise oder von wenigstens einem zweiten Ablenkelement (13b) oder von wenigstens einem zweiten Strahlteiler (14b), aufzunehmen, winkelig umzulenken und parallel zueinander zu jeweils genau einer Mikro-Linse des Mikro-Linsen-Arrays (12) zu führen.

14. Einkopplungsvorrichtung (1) nach einem der Ansprüche 1 bis 10,
wobei das Fokussierelement (12) eine Freiformoptik (12) ist,
ferner mit einer Mehrzahl von Mikro-Keilen (17b), welche ausgebildet und angeordnet sind, jeweils genau einen abgelenkten oder geteilten Laserstrahl (A) vom ersten Ablenkelement (13a) oder vom ersten Strahlteiler (14a), vorzugsweise oder von wenigstens einem zweiten Ablenkelement (13b) oder von wenigstens einem zweiten Strahlteiler (14b), aufzunehmen, winkelig umzulenken und parallel zueinander zum Fokussierelement (12) zu führen.

15. Einkopplungsvorrichtung (1) nach einem der vorangehenden Ansprüche,
wobei die Faserelemente (11a) des Faser-Arrays (11) jeweils einen Modenfeldadapter (11d) aufweisen, um genau einen abgelenkten oder geteilten Laserstrahl (A) aufzunehmen, und/oder
wobei die Faserelemente (11a) des Faser-Arrays (11) jeweils ein lichtentfernendes Element (11e) aufweisen, welches ausgebildet ist, nicht in einen Faserkern (11b) des jeweiligen Faserelementes (11a) eingekoppeltes Laserlicht des jeweiligen abgelenkten oder geteilten Laserstrahls (A) aus dem Faserelement (11a), vorzugsweise aus einem Fasermantel (11c) des Faserelementes (11a), zu entfernen, und/oder
wobei wenigstens das erste Ablenkelement (13a) oder der erste Strahlteiler (14a), das Fokussierelement (12) und das Faser-Array (11) ausgebildet sind, den eingehenden Laserstrahl (A) mit einer optischen Leistung von wenigstens 100 W aufzunehmen.
